# EUROPEAN PATENT APPLICATION

(11) **EP 4 568 434 A1**
(43) Date of publication of application: **11.06.2025**
(21) Application number: 23853100.8
(22) Date of filing: 11.08.2023
(51) Int. Cl.: H05K 7/20, H04M 1/02, G06F 1/16, H05K 5/06

(54) **ELECTRONIC DEVICE COMPRISING HEAT DISSIPATION MEMBER**

(30) Priority: 11.08.2022 KR 20220100646; 15.09.2022 KR 20220116439; 01.08.2023 WO PCT/KR2023/011222
(71) Applicant: Samsung Electronics Co., Ltd., Suwon-si, Gyeonggi-do 16677 (KR)
(72) Inventor: MIN, Byeonguk, Suwon-si Gyeonggi-do 16677 (KR)
(74) Representative: Gulde & Partner
(86) International application number: PCT/KR2023/012005
(87) International publication number: WO 2024/035235

(57) **Abstract**

An electronic device according to an embodiment of the present disclosure may comprise: a first housing; a second housing; a hinge structure connected to the first housing and the second housing to enable the first housing and the second housing to be rotated while the electronic device changes the state thereof between an unfolded state and a folded state; a flexible display accommodated in the first housing and the second housing and located to be unfolded or bent while the state of the electronic device changes between the unfolded state and the folded state; and a heat dissipation member (310) including a first area (S1) located to overlap at least a portion of the first housing when viewed in a direction perpendicular to the first housing, and a second area (S2) extending from the first area and located to overlap at least a portion of the second housing when viewed in a direction perpendicular to the second housing. When the state of the electronic device changes between the unfolded state and the folded state, the first area of the heat dissipation member may be fixed to the first housing or at least one part accommodated in the first housing, and the second area may be located to slide relative to the second housing.

## Description

### [Technical Field]

Various embodiments of the present invention relate to an electronic device including a heat dissipation member.

### [Background Art]

With the development of information and communication technology and semiconductor technology, various functions are packed in one portable electronic device. For example, an electronic device may implement not only communication functions but also entertainment functions, such as playing games, multimedia functions, such as playing music and videos, communication and security functions for mobile banking, and scheduling and e-wallet functions. These electronic devices have been downsized to be conveniently carried by users.

As mobile communication services extend up to multimedia service sectors, electronic devices require a larger display to allow users satisfactory use of multimedia services as well as voice call or text messaging services. This, however, trades off the trend of electronic devices being compact.

Due to recent demand for high integration and high performance, such as making smartphones or other portable electronic devices smaller and lighter, and application of the state-of-the-art technology, e.g., 5G, significant heat may be generated and the heat generation density may increase in the portable electronic devices. Accordingly, various heat diffusion structures are required to efficiently dissipate heat generated from heat sources inside electronic devices.

### [Detailed Description of the Invention]

### [Technical Problem]

An electronic device according to an embodiment of the disclosure may comprise a first housing, a second housing, a hinge structure connected to the first housing and the second housing such that the first housing and the second housing are rotatable while the electronic device is in transition between a unfolded state and a folded state, a flexible display accommodated at the first housing and the second housing, and positioned to be unfolded or bent while the electronic device is in transition between the unfolded state and the folded state, and a heat dissipation member 310 including a first area S1 positioned to overlap with at least a portion of the first housing, when viewed from a direction perpendicular to the first housing and a second area S2 extending from the first area and positioned to overlap with at least a portion of the second housing, when viewed from a direction perpendicular to the second housing. While the electronic device is in transition between the unfolded state and the folded state, the first area of the heat dissipation member may be fixed to the first housing or at least one component accommodated in the first housing, and the second area of the heat dissipation member may be configured to slide with respect to the second housing.

An electronic device according to an embodiment of the disclosure may comprise a first housing, a second housing, a hinge structure connected to the first housing and the second housing so that the first housing and the second housing are rotatable while the electronic device is changed between an unfolded state and a folded state, a flexible display accommodated in the first housing and the second housing and positioned to be unfolded or bent while the electronic device is changed between the unfolded state and the folded state, and a heat dissipation member including a first area positioned to overlap at least a portion of the first housing when viewed in a direction perpendicular to the first housing, and a second area extending from the first area and positioned to overlap at least a portion of the second housing when viewed in a direction perpendicular to the second housing. The heat dissipation member may include a thermally conductive sheet at least partially formed to be slidable and a metal sheet attached to the thermally conductive sheet and at least partially bendable.

However, the objects of the disclosure are not limited to the foregoing objects but rather may be expanded in various manners without departing from the spirit and scope of the disclosure.

### [Brief Description of the Drawings]

FIG. 1 is a block diagram illustrating an electronic device in a network environment according to an embodiment of the disclosure;
FIG. 2 is a view illustrating an unfolded state of an electronic device according to an embodiment of the disclosure;
FIG. 3 is a view illustrating a folded state of an electronic device according to an embodiment of the disclosure;
FIG. 4 is an exploded perspective view illustrating an electronic device according to an embodiment of the disclosure;
FIG. 5 is a cross-sectional view taken along a length direction in an unfolded state of an electronic device according to an embodiment of the disclosure;
FIG. 6 is a cross-sectional view taken along a length direction in an intermediate state (between an unfolded state and a folded state) of an electronic device according to an embodiment of the disclosure;
FIG. 7 is a cross-sectional view taken along a length direction in a folded state of an electronic device according to an embodiment of the disclosure;
FIG. 8 is a view illustrating a guide structure for sliding a heat dissipation member according to an embodiment of the disclosure;
FIG. 9 is a cross-sectional view taken along a length direction in an unfolded state of an electronic device according to an embodiment of the disclosure;
FIG. 10 is a cross-sectional view taken along a length direction in a folded state of an electronic device according to an embodiment of the disclosure;
FIG. 11 is a see-through view illustrating a disposition of a heat dissipation member and a heat diffusion direction in an unfolded state of an electronic device according to an embodiment of the disclosure;
FIG. 12A is a view illustrating the degree of heat diffusion when a heat dissipation member is disposed in a first housing;
FIG. 12B is a view illustrating the degree of heat diffusion when a heat dissipation member extends to be disposed in a first housing and a second housing according to an embodiment of the disclosure;
FIG. 13A is a view illustrating an unfolded state of an electronic device according to an embodiment of the disclosure;
FIG. 13B is a view illustrating a folded state of an electronic device according to an embodiment of the disclosure;
FIG. 14 is an exploded perspective view illustrating an electronic device according to an embodiment of the disclosure;
FIG. 15 is a view illustrating internal components in an unfolded state of an electronic device according to an embodiment of the disclosure;
FIG. 16 is a cross-sectional view illustrating an arrangement relationship between a display and a housing, taken along a length direction (e.g., E-E' of FIG. 15) in an unfolded state of an electronic device according to an embodiment of the disclosure;
FIG. 17 is a cross-sectional view illustrating an electronic device, taken along a length direction (e.g., E-E' of FIG. 15) in an unfolded state of the electronic device according to an embodiment of the disclosure;
FIG. 18 is a view illustrating internal components facing rearward in an unfolded state of an electronic device according to an embodiment of the disclosure;
FIG. 19 is a view illustrating internal components facing forward in an unfolded state of an electronic device according to an embodiment of the disclosure;
FIG. 20 is a view illustrating internal components facing forward in an unfolded state of an electronic device according to an embodiment of the disclosure;
FIG. 21 is a view illustrating a rear surface of a display and a heat dissipation member disposed on the rear surface in an unfolded state of an electronic device according to an embodiment of the disclosure;
FIG. 22 is a view illustrating a rear surface of a display and a heat dissipation member disposed on the rear surface in an unfolded state of an electronic device according to an embodiment of the disclosure;
FIG. 23 is an enlarged, cross-sectional view illustrating area P of FIG. 17 according to an embodiment of the disclosure;
FIG. 24A is a view illustrating a state in which a second display area of a display is received in a housing according to an embodiment of the disclosure;
FIG. 24B is a view illustrating a state in which a second display area of a display is exposed to the outside of a housing according to an embodiment of the disclosure;
FIG. 25A is a cross-sectional view taken along line F-F' of FIG. 24A according to an embodiment of the disclosure;
FIG. 25B is a cross-sectional view taken along line G-G' of FIG. 24B according to an embodiment of the disclosure;
FIG. 26A is a perspective view illustrating an unfolded state of an electronic device according to an embodiment of the disclosure;
FIG. 26B is a perspective view illustrating an unfolded state of an electronic device according to an embodiment of the disclosure;
FIG. 26C is a perspective view illustrating a folded state of an electronic device according to an embodiment of the disclosure;
FIG. 27 is a see-through view illustrating internal components (e.g., a heat dissipation member and a heat source) in a folded state of an electronic device according to an embodiment of the disclosure;
FIG. 28 is a see-through view illustrating internal components (e.g., a heat dissipation member and a heat source) in a folded state of an electronic device according to an embodiment of the disclosure;
FIG. 29 is a see-through view illustrating internal components (e.g., a heat dissipation member and a heat source) in a folded state of an electronic device according to an embodiment of the disclosure; and
FIG. 30 is a see-through view illustrating internal components (e.g., a heat dissipation member and a heat source) in a folded state of an electronic device according to an embodiment of the disclosure.

### [Mode for Carrying out the Invention]

The electronic device according to embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

An embodiment of the disclosure and terms used therein are not intended to limit the technical features described in the disclosure to specific embodiments, and should be understood to include various modifications, equivalents, or substitutes of the embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

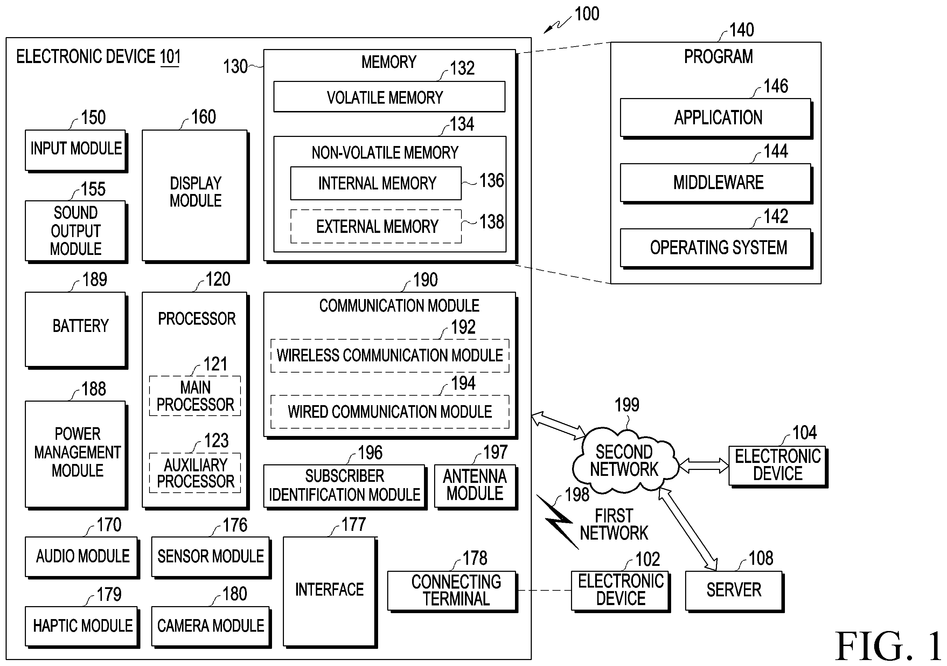

FIG. 1 is a block diagram illustrating an electronic device in a network environment according to an embodiment of the disclosure.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. In an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

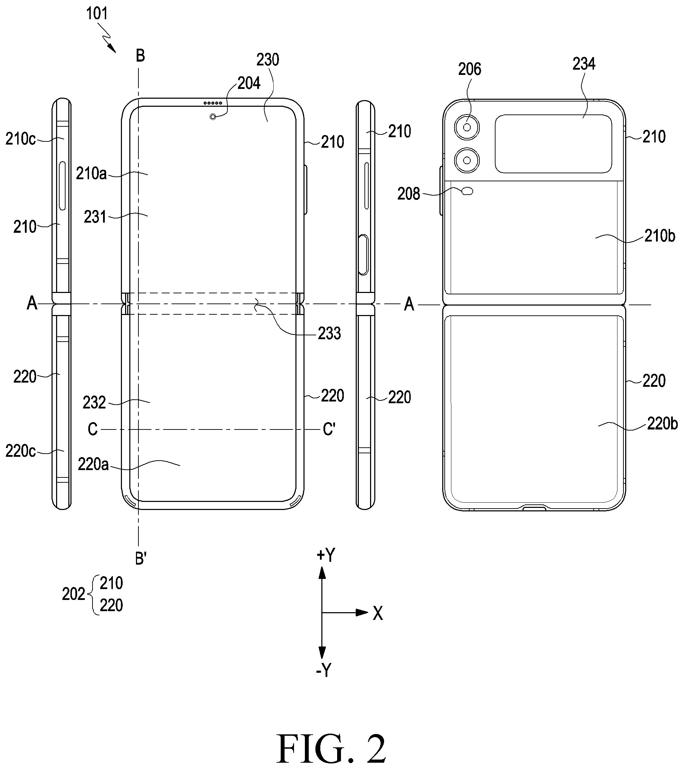

FIG. 2 is a view illustrating an unfolded state of an electronic device according to an embodiment of the disclosure.

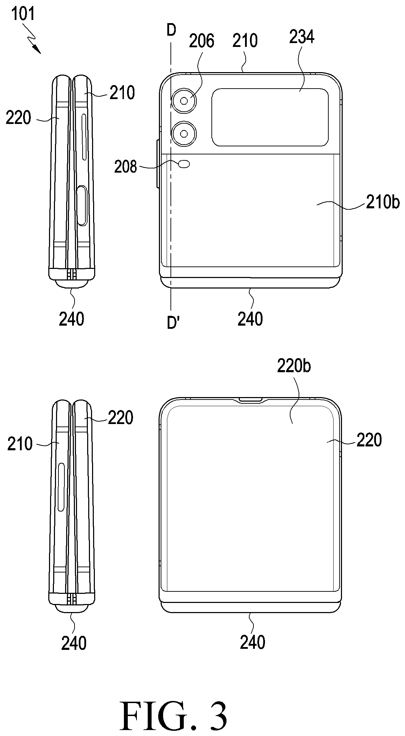

FIG. 3 is a view illustrating a folded state of an electronic device according to an embodiment of the disclosure.

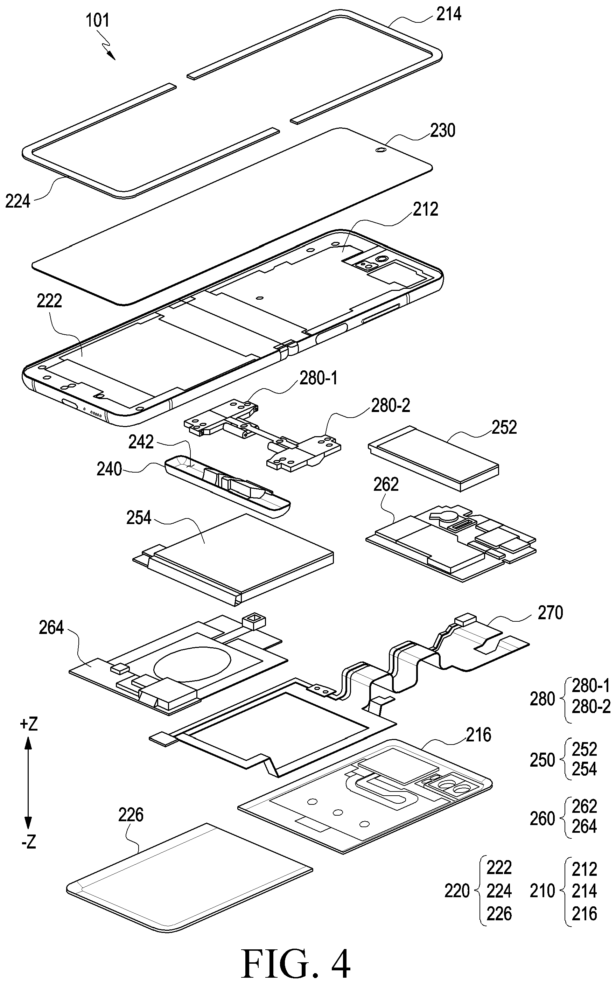

Referring to FIGS. 2 and 3, an electronic device 101 may include a housing 202 for accommodating components (e.g., the battery 250 and/or circuit board 260 of FIG. 4) of the electronic device 101 and a flexible display or foldable display 230 (hereinafter, the display 230) connected to the housing 202. According to an embodiment, the housing 202 may be referred to as a foldable housing.

According to an embodiment, the housing 202 may include a first housing 210 and a second housing 220 configured to relatively rotate about the first housing 210.

According to an embodiment, the first housing 210 and/or the second housing 220 may form a portion of the exterior of the electronic device 101. According to an embodiment, the surface where the display 230 is visually exposed is defined as a front surface (e.g., a first front surface 210a and a second front surface 220a) of the electronic device 101 and/or housing 202. A surface opposite to the front surface is defined as a rear surface (e.g., the first rear surface 210b and the second rear surface 220b) of the electronic device 101. A surface surrounding at least a portion of the space between the front surface and the rear surface is defined as a side surface (e.g., the first side surface 210c and the second side surface 220c) of the electronic device 101.

According to an embodiment, the first housing 210 may be rotatably connected to the second housing 220. For example, the first housing 210 may be rotatably connected to the second housing 220 by a hinge structure (e.g., the hinge structure 280 of FIG. 4). The electronic device 101 may turn into a folded state (e.g., FIG. 2) or unfolded state (e.g., FIG. 3). **In** the folded state of the electronic device 101, the first front surface 210a may face the second front surface 220a and, in the unfolded state, the direction in which the first front surface 210a faces may be the same as the direction in which the second front surface 220a faces. For example, in the unfolded state, the first front surface 210a may be positioned on substantially the same plane as the second front surface 220a. According to an embodiment, the second housing 220 may provide a motion relative to the first housing 210. According to an embodiment, the first housing 210 may receive a force to be rotated about the second housing 202 using an elastic member (not shown).

According to an embodiment, the first housing 210 and the second housing 220 are disposed on both sides of the folding axis A and be overall symmetrical in shape with respect to the folding axis A. The angle between the first housing 210 and the second housing 220 may be changed depending on whether the electronic device 101 is in the unfolded state, the folded state, or an intermediate state between the unfolded state and the folded state.

According to an embodiment, the electronic device 101 may include a hinge cover 240. At least a portion of the hinge cover 240 may be disposed between the first housing 210 and the second housing 220. According to an embodiment, the hinge cover 240 may be hidden by a portion of the first housing 210 and second housing 220 or be exposed to the outside depending on the state of the electronic device 101. According to an embodiment, the hinge cover 240 may protect the hinge structure (e.g., the hinge structure 280 of FIG. 4) from an external impact of the electronic device 101. According to an embodiment, the hinge cover 240 may be referred to as a hinge housing.

According to an embodiment, as shown in FIG. 2, in the unfolded state of the electronic device 101, the hinge cover 240 may be hidden, and thus not exposed, by the first housing 210 and the second housing 220. As another example, as shown in FIG. 3, in the folded state (e.g., a fully folded state) of the electronic device 101, the hinge cover 240 may be exposed to the outside between the first housing 210 and the second housing 220. As another example, in an intermediate state in which the first housing 210 and the second housing 220 are folded with a certain angle, the hinge cover 240 may be partially exposed to the outside between the first housing 210 and the second housing 220. However, in this case, the exposed area may be less than the fully folded state. In an embodiment, the hinge cover 240 may include a curved surface.

According to an embodiment, the display 230 may visually provide information to the outside (e.g., the user) of the electronic device 101. The display 230 may include, for example, a hologram device, or a projector and control circuitry to control a corresponding one of the display, hologram device, and projector. According to an embodiment, the display 230 may include a touch sensor configured to detect a touch, or a pressure sensor configured to measure the intensity of a force generated by the touch.

According to an embodiment, the display 230 may mean a display at least a portion of which may be transformed into a flat or curved surface. For example, the display 230 may be formed to be transformable in response to the motion of the second housing 220 relative to the first housing 210. According to an embodiment, the display 230 may include a folding area 233, a first display area 231 disposed on one side of the folding area 233 (e.g., the upper (+Y) direction), and a second display area 232 disposed on the opposite side of the folding area 233 (e.g., lower (-Y) direction). According to an embodiment, in the unfolded state (e.g., FIG. 2) of the electronic device 101, the folding area 233 may be positioned above the hinge structure (e.g., the hinge structure 280 of FIG. 4). For example, at least a portion of the folding area 233 may face the hinge structure 280. According to an embodiment, the folding area 233 may be referred to as a portion of the display 230 at least a portion of which is bent based on the state change (e.g., unfolding or folding) of the electronic device 101. According to an embodiment, the first display area 231 may be disposed on the first housing 210, and the second display area 232 may be disposed on the second housing 220. According to an embodiment, the display 230 may be accommodated in the first housing 210 and the second housing 220.

However, the segmentation of the display 230 as shown in FIG. 2 is merely an example, and the display 230 may be divided into a plurality of (e.g., four or more, or two) areas depending on the structure or function of the display 200.

Further, in the embodiment illustrated in FIG. 1, the display 230 may be divided into the areas by the folding area 233 or folding axis (axis A) extending in parallel with the X axis but, in another embodiment, the display 230 may be divided into the areas with respect to another folding area (e.g., a folding area parallel with the X axis) or another folding axis (e.g., a folding axis parallel with the X axis). According to an embodiment, the display 230 may be coupled with or disposed adjacent to a touch detection circuit, a pressure sensor capable of measuring the strength (pressure) of touches, and/or a digitizer for detecting a magnetic field-type stylus pen.

According to an embodiment, the electronic device 101 may include a rear display 234. The rear display 234 may be disposed to face in a different direction from the display 230. For example, the display 230 may be visually exposed through the front surface (e.g., the first front surface 210a and/or the second front surface 220a) of the electronic device 101, and the rear display 234 may be visually exposed through the rear surface (e.g., the first rear surface 210b) of the electronic device 101.

According to an embodiments, the electronic device 101 may include at least one camera module 204 and 206 and a flash 208. According to an embodiment, the electronic device 101 may include a front camera module 204 exposed through the front surface (e.g., the first front surface 210a) and/or a rear camera module 206 exposed through the rear surface (e.g., the first rear surface 220b). The camera modules 204 and 206 may include one or more lenses, an image sensor, a flash, and/or an image signal processor. The flash 208 may include a light emitting diode (LED) or a xenon lamp. In an embodiment, two or more lenses (infrared camera, wide-angle and telephoto lens) and image sensors may be disposed on one surface of the electronic device 101. The front camera module 204 and/or the rear camera module 206 may capture a still image and/or a video. According to an embodiment, the camera module 204 or 206 may include one or more lenses, image sensors, image signal processors, or flashes.

FIG. 4 is an exploded perspective view illustrating an electronic device according to an embodiment of the disclosure.

Referring to FIG. 4, an electronic device 101 may include a first housing 210, a second housing 220, a display 230, a hinge cover 240, a battery 250, a printed circuit board 260, a flexible printed circuit board 270, and a hinge structure 280. The configuration of the first housing 210, the second housing 220, the display 230, and the hinge cover 240 of FIGS. 2 and 3 may be identical in whole or part to the configuration of the first housing 210, the second housing 220, the display 230, and the hinge cover 240 of FIG. 1 and/or 2. The structure of FIG. 4 may be selectively combinable with the structures of FIGS. 2 and 3.

According to an embodiment, the electronic device 101 may include a first supporting member 212 or a second supporting member 222. For example, the first housing 210 may include a first supporting member 212, and the second housing 220 may include a second supporting member 222. According to an embodiment, the first supporting member 212 and/or the second supporting member 222 may support components (e.g., the display 230, the battery 250, and the printed circuit board 260) of the electronic device 101.

According to an embodiment, the first supporting member 212 and/or the second supporting member 222 may be formed of a metal material and/or a non-metal (e.g., polymer) material. According to an embodiment, the first supporting member 212 may be disposed between the display 230 and the battery 250. For example, the display 230 may be coupled to one surface of the first supporting member 212, and the battery 250 and the printed circuit board 260 may be disposed on the other surface.

According to an embodiment, the electronic device 101 may include a first protection member 214 or a second protection member 224. For example, the first housing 210 may include a first protection member 214, and the second housing 220 may include a second protection member 224. According to an embodiment, the protection members 214 and 224 may protect the display 230 from external impact. For example, the first protection member 214 may surround at least a portion of a portion (e.g., the first display area 231 of FIG. 2) of the display 230, and the second protection member 224 may surround at least a portion of another portion (e.g., the second display area 232 of FIG. 2) of the display 230. According to an embodiment, the first protection member 214 may be referred to as a first deco member, and the second protection member 224 may be referred to as a second deco member.

According to an embodiment, the housings 210 and 220 may include a first rear plate 216 and a second rear plate 226. For example, the first housing 210 may include a first rear plate 216 connected to the first supporting member 212, and the second housing 220 may include a second rear plate 226 connected to the second supporting member 222. According to an embodiment, the rear plates 216 and 226 may form at least a portion of the exterior of the electronic device 101. For example, the first rear plate 216 may form a first rear surface (e.g., the first rear surface 210b of FIG. 1), and the second rear plate 226 may form a second rear surface (e.g., the second rear surface 220b of FIG. 1). According to an embodiment, the first battery 252 and the first printed circuit board 262 may be disposed between the first supporting member 212 and the first rear plate 216. The second battery 254 and the second printed circuit board 264 may be disposed between the second supporting member 222 and the second rear plate 226.

According to an embodiment, the hinge cover 240 may accommodate at least a portion of the hinge structure 280. For example, the hinge cover 240 may include an accommodation recess 242 for accommodating the hinge structure 280. According to an embodiment, the hinge cover 240 may be coupled to the hinge structure 280. According to an embodiment, in the unfolded state of the electronic device 101, at least a portion of the hinge cover 240 may be positioned between the hinge structure 280 and the housings 210 and 220. According to an embodiment, the hinge cover 240 may guide movement of the housings 210 and 220. For example, the first housing 210 and the second housing 220 each may rotate about the hinge cover 240 in a state connected to the hinge cover 240.

According to an embodiment, the battery 250 may be a device for supplying power to at least one component of the electronic device 101. The battery 189 may include a primary cell which is not rechargeable, a secondary cell which is rechargeable, or a fuel cell. The battery 250 may be integrally or detachably disposed inside the electronic device 101. According to an embodiment, the battery 250 may include a first battery 252 disposed in the first housing 210 and a second battery 254 disposed in the second housing 220. For example, the first battery 252 may be disposed on the first supporting member 212. The second battery 254 may be disposed on the second supporting member 222.

According to an embodiment, a processor, memory, and/or an interface may be mounted on the printed circuit board 260. According to an embodiment, the printed circuit board 260 may include a first printed circuit board 262 disposed in the first housing 210 and a second printed circuit board 264 disposed in the second housing 220.

According to an embodiment, the flexible printed circuit board 270 may electrically connect a component (e.g., first printed circuit board 262) positioned in the first housing 210 with a component (e.g., first printed circuit board 262) positioned in the second housing 220. According to an embodiment, at least a portion of the flexible printed circuit board 270 may cross the hinge cover 240 and/or the hinge structure 280. For example, a portion of the flexible printed circuit board 270 may be disposed in the first housing 210, and another portion thereof may be disposed in the second housing 220. According to an embodiment, the flexible printed circuit board 270 may include a first flexible printed circuit board 272 connected to an antenna and a second flexible printed circuit board 274 connected to the display 230.

According to an embodiment, the hinge structure 280 may include a plurality of hinge structures 280-1 and 280-2 disposed in parallel. For example, the hinge structure 280 may include a first hinge structure 280-1 and a second hinge structure 280-2 spaced apart from the first hinge structure 280-1. According to an embodiment, the first hinge structure 280-1 may be symmetrical with the second hinge structure 280-2 with respect to the length direction (e.g., the Y-axis direction) of the electronic device 101.

According to an embodiment, FIGS. 2 to 4 disclose the electronic device as a flip-type in-foldable electronic device, but the electronic device is not limited thereto. For example, there may be included various electronic devices including a flexible display that is bendable or rollable in a partial area (e.g., folding area), such as out-foldable electronic devices, multi-foldable electronic devices capable of in-out folding multiple times, or electronic devices including a display extendable through a slide between housings.

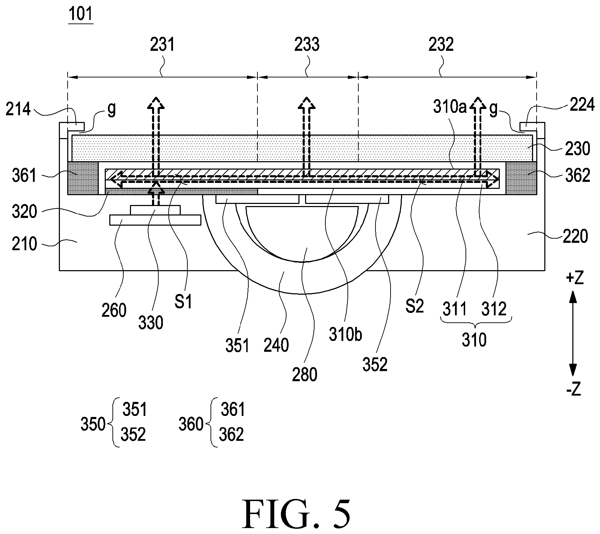

FIG. 5 is a cross-sectional view taken along a length direction in an unfolded state of an electronic device according to an embodiment of the disclosure.

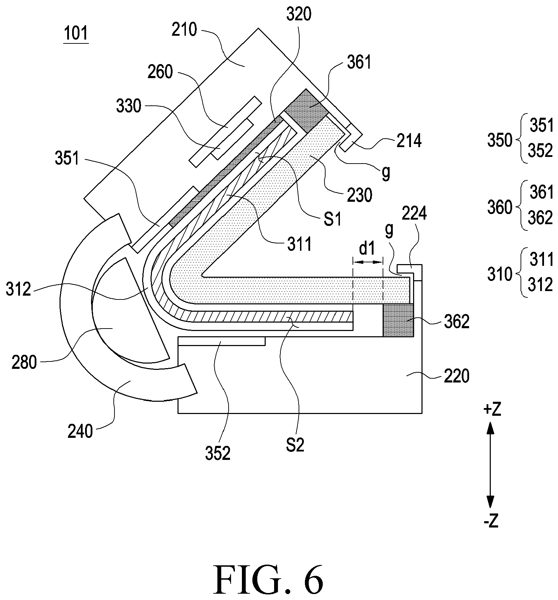

FIG. 6 is a cross-sectional view taken along a length direction in an intermediate state (between an unfolded state and a folded state) of an electronic device according to an embodiment of the disclosure.

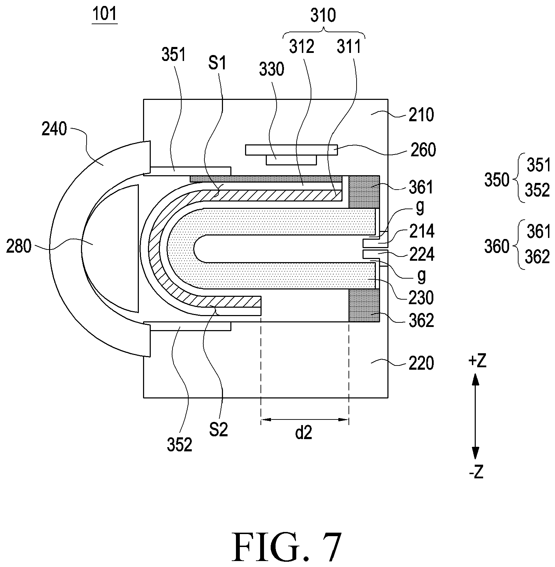

FIG. 7 is a cross-sectional view taken along a length direction in a folded state of an electronic device according to an embodiment of the disclosure.

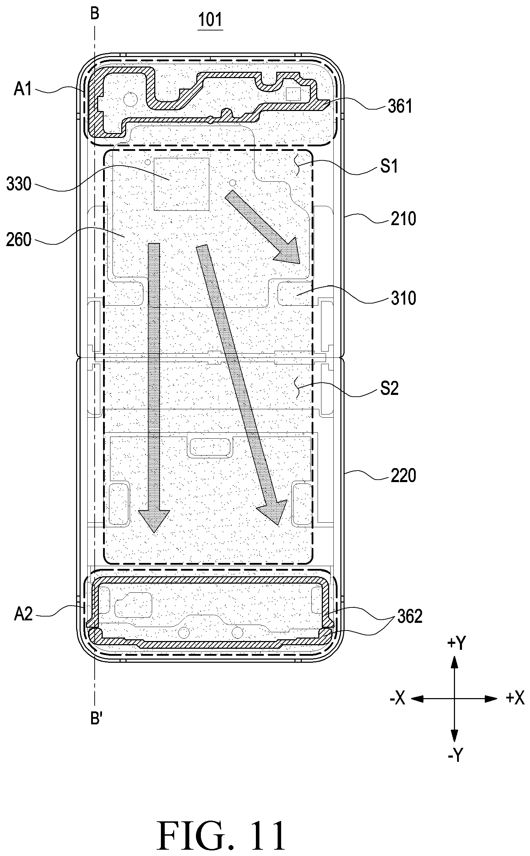

FIG. 5 is a schematic view taken along line B-B' of FIG. 2 (or line B-B' of FIG. 11), and FIG. 7 is a schematic cross-sectional view taken along line D-D' of FIG. 3.

In an embodiment, the electronic device 101 may include a first housing 210, a second housing 220, a hinge structure 280, a display 230, a printed circuit board 260, and a heat dissipation member 310. The configuration of the first housing 210, the second housing 220, the hinge structure 280, the display 230, and the printed circuit board 260 of FIGS. 5, 6, and 7 may be identical in whole or part to the configuration of the first housing 210, the second housing 220, the hinge structure 280, the display 230, and the first printed circuit board 260 of FIGS. 1 to 4. The structure of FIGS. 5, 6, and 7 may be selectively coupled to the structure of FIGS. 2 to 4.

According to an embodiment, the display 230 (e.g., a flexible display) may be configured to be unfolded or folded (e.g., bent or rolled) based on the relative movement of the first housing 210 or the second housing 220, and may include a first display area 231 connected to the first housing 210, a second display area 232 connected to the second housing 220, and a folding area 233 connecting the first display area 231 and the second display area 232.

According to an embodiment, the display 230 may be disposed on the first and second housings 210 and 220, and the waterproof member 360 may be disposed near the edge of the display 230 to prevent foreign substances (e.g., liquids) from entering the electronic device 101. According to an embodiment, a first protection member (e.g., the first protection member 214 of FIG. 4) may be disposed to surround an upper edge of the display 230 to protect the display 230. A gap g may be formed between the upper side (e.g., one side facing in the +Z-axis direction) of the display 230 and the first protection member 214, which are substantially spaced apart from each other by a predetermined interval, and foreign substances such as moisture may be introduced into the electronic device 101 through the gap g. The first waterproof member 361 may seal the inflow passage formed between the first housing 210 and the display 230, thereby reducing or limiting the inflow of the foreign substance into the first housing 210. For example (see FIG. 11), a plurality of electrical components (e.g., a camera or a speaker) may be positioned near the upper edge A1 of the first housing 210, and the first waterproof member 361 may be disposed in a closed curve shape to surround the plurality of electrical components. The first waterproof member 361 may seal between one area (e.g., the first display area 231) of the display 230 and the first housing 210 to prevent water from entering the electrical components. The first waterproof member 361 may have a tape shape. According to an embodiment, a second protection member (e.g., the second protection member 224 of FIG. 4) may be disposed to surround a lower edge of the display 230 to protect the display 230. A gap g may be formed between the upper side (e.g., one side facing in the +Z-axis direction) of the display 230 and the second protection member 224, which are substantially spaced apart from each other by a predetermined interval, and foreign substances such as moisture may be introduced into the electronic device 101 through the gap g. The second waterproof member 362 may seal the inflow passage formed between the second housing 220 and the display 230, thereby reducing or limiting the inflow of the foreign substance into the second housing 220. For example (see FIG. 11), a plurality of electrical components (e.g., a flexible circuit board and a receiver) and a sub circuit board on which the electrical components are mounted may be positioned near the lower edge A2 of the second housing 220, and the second waterproof member 362 may be disposed in a closed curve shape to surround the plurality of electrical components. As the second waterproof member 362 is disposed near the edge of the sub circuit board, the second waterproof member 362 may be disposed to overlap the sub circuit board. The second waterproof member 362 may seal between one area (e.g., the second display area 232) of the display 230 and the second housing 220 to prevent water from entering the electrical components. The second waterproof member 362 may have a tape shape.

According to an embodiment, the printed circuit board 260 may be disposed in the first housing 210 and/or the second housing 220, and a plurality of electrical elements may be disposed on at least one surface of the printed circuit board 260. Some of the plurality of electrical elements may be a heat source 330 that generates heat, e.g., at least one chip disposed on at least one surface of the printed circuit board 260, and may include at least one of a power management integrated circuit (PMIC), a power amplifier (PAM), an application processor (AP), a communication processor (CP), a charge integrated circuit (Charger IC), or a DC converter. In the illustrated embodiment, the heat source 330 may be an application processor (AP) or a power management integrated circuit (PMIC).

According to an embodiment, the first printed circuit board (e.g., the first printed circuit board 262 of FIG. 4) of the printed circuit board 260 may be positioned in the first housing 210, and the heat source 330 may be disposed on the first printed circuit board 262. According to an embodiment, the second printed circuit board (e.g., the second printed circuit board 264 of FIG. 4) of the printed circuit board 260 may be positioned in the second housing 220, and the heat source 330 may be disposed on the second printed circuit board 264.

According to an embodiment, the heat dissipation member 310 may include a first area S1 disposed on the first housing 210, and a second area S2 extending from the first area S1 and disposed on the second housing 220. For example, when viewed toward the display 230, the first area S1 of the heat dissipation member 310 may overlap a portion of the first housing 210, and the second area S2 may overlap a portion of the second housing 220.

According to an embodiment, the heat dissipation member 310 may include a first area S1 disposed adjacent to the heat source 330 disposed on the printed circuit board 260 and a second area S2 extending from the first area S1. The first area S1 of the heat dissipation member 310 may overlap a portion of the first display area 231 and/or the folding area 233 of the display 230, and the second area S2 of the heat dissipation member 310 may overlap the second display area 232 and/or the folding area 233 of the display 230. As the heat generated from the heat source 330 is transferred to the first area S1 of the heat dissipation member 310 and then diffused to the second area S2, the heat may not be concentrated in a certain portion (e.g., the first display area 231) of the display 230, but the heat may be diffused throughout the display 230.

According to an embodiment, as the heat source 330 is disposed to contact the first area S1 of the heat dissipation member 310, the heat dissipation member 310 may directly receive and diffuse heat generated from the heat source 330. According to an embodiment, as the heat source 330 is connected to the first area S1 of the heat dissipation member 310 through the first housing 210, heat generated from the heat source 330 may be diffused through the first housing 210 and the heat dissipation member 310. According to an embodiment, as the heat source 330 is connected to the first area S1 of the heat dissipation member 310 through a thermal interface material (TIM) member disposed through the first housing 210, heat generated from the heat source 330 may be diffused through the TIM member and the heat dissipation member 310. According to an embodiment, at least one thermal interface material (TIM) member may be disposed between the heat source 330 and the first area S1 of the heat dissipation member 310 to provide diffusion and/or shielding performance. For example, when the heat source 330 is an application processor (AP), the AP TIM on the AP, the nano TIM, and the first housing 310 (and/or the TIM mounted in the first housing 310) may be sequentially disposed to provide a diffusion path of heat generated in the AP. The AP TIM on the AP, the nano TIM, and the TIM mounted in the first housing 310 may be selectively disposed.

According to an embodiment, a partial area of the heat dissipation member 310 may remain fixed to the first housing 210 or the second housing 220, and another partial area may be formed to be slidable. For example, at least a portion of the first area S1 of the heat dissipation member 310 may be attached onto the first housing 210, and may be fixed when the electronic device 101 operates from the unfolded state to the folded state. The second area S2 of the heat dissipation member 310 may be disposed over the second housing 220, but may not be attached thereto, and thus, may slide with respect to at least a portion of the fixed first area S1 when the electronic device 101 operates from the unfolded state to the folded state.

According to an embodiment, when the electronic device 101 operates from the unfolded state to the folded state, at least a portion of the heat dissipation member 310 may be bent to correspond to the display 230. For example, in the unfolded state of the electronic device 101, the central area of the heat dissipation member 310 may be disposed to overlap the bending area 233 of the display 230 and may be in a flat state. When the electronic device 101 operates from the unfolded state to the folded state, and in the folded state, the central area of the heat dissipation member 310 (e.g., the stacked thermally conductive sheet 311 and metal sheet 312) may be disposed to overlap the bending area 233 of the display 230 and may be in the bent state.

According to an embodiment, when the electronic device 101 operates from the unfolded state to the folded state, one end of the second area S2 of the heat dissipation member 310 may slide toward the hinge structure 280, and the area in which the display 230 except for the heat dissipation member 310 and the second housing 220 face each other may increase.

According to an embodiment, the heat dissipation member 310 may be disposed to substantially face a substantial portion of the display 230. The first display area 231 of the display 230 may face the first housing 210, and the edge portion of the first display area 231 may seal the gap formed by the first housing 210 and the first display area 231 by the first waterproof member 361. The second display area 232 of the display 230 may face the second housing 220, and the edge portion of the second display area 232 may seal the gap formed by the second housing 220 and the first display area 231 by the second waterproof member 362. The heat dissipation member 310 may be disposed in an inner space surrounded by the display 230, the first and second housings 210 and 220, and the first and second waterproof members 361 and 362. For example, the front surface 310a (e.g., one surface facing in the first direction (+Z-axis direction)) of the heat dissipation member 310 may face the display 230, and the rear surface 310b (e.g., one surface facing in the second direction (-Z-axis direction)) may face the first and second housings 210 and 220. One side surface of the heat dissipation member 310 may be disposed adjacent to (or facing) the first waterproof member 361, and the other side surface may be disposed adjacent to (or facing) the second waterproof member 362.

According to an embodiment, the heat dissipation member 310 may be stacked in a plurality of layers. The heat dissipation member 310 may include a thermally conductive sheet 311 and a metal sheet 312. For example, the heat dissipation member 310 may include a thermally conductive sheet 311 facing the display 230 and a metal sheet 312 stacked on the rear surface (e.g., one surface facing the -Z-axis) of the thermally conductive sheet 311. As another example, the heat dissipation member 310 may include a metal sheet 312 facing the display 230 and a thermally conductive sheet 311 stacked on the rear surface (e.g., one surface facing the -Z-axis) of the metal sheet 312.

According to an embodiment, the thermally conductive sheet 311 of the heat dissipation member 310 may include a material for diffusing heat generated from the heat source 330. The thermally conductive sheet 311 may include at least one of graphite, carbon nanotubes, natural recycled materials, silicone, or silicon. According to an embodiment, the thermally conductive sheet 311 may be formed to substantially face the first display area 231, the bending area 233, and the second display area 232 of the display 230. The area of the thermally conductive sheet 311 facing the first display area 231 may be an area other than the first waterproof member 361 in contact with the first display area 231. The area of the thermally conductive sheet 311 facing the second display area 232 may be an area other than the second waterproof member 362 in contact with the second display area 232. When the electronic device 101 operates from the unfolded state to the folded state, as the thermally conductive sheet 311 slides, at least a portion of the area of the thermally conductive sheet 311 facing the second display area 232 may be variable (e.g., bent).

According to an embodiment, the metal sheet 312 of the heat dissipation member 310 may be stacked to have a size corresponding to that of the thermally conductive sheet 311 to prevent damage to the thermally conductive sheet 311. For example, when the electronic device 101 operates from the unfolded state to the folded state, a partial area of the thermally conductive sheet 311 is bent, and thus there is a risk of damage. As the metal sheet 312 is stacked and attached to a bendable area as well as the flat area of the thermally conductive sheet 311, the metal sheet 312 may slide together when the thermally conductive sheet 311 slides, thereby limiting crumpling and damage to the thermally conductive sheet 311.

According to an embodiment, the metal sheet 312, together with the thermally conductive sheet 311, may diffuse heat generated from the heat source 330. The metal sheet 312 may be formed to substantially face the first display area 231, the bending area 233, and the second display area 232 of the display 230. The area of the metal sheet 312 facing the first display area 231 may be an area other than the first waterproof member 361 in contact with the first display area 231. The area of the metal sheet 312 facing the second display area 232 may be an area other than the second waterproof member 362 in contact with the second display area 232. When the electronic device 101 operates from the unfolded state to the folded state, as the metal sheet 312 slides together with the thermally conductive sheet 311, the area of the metal sheet 312 facing the second display area 232 may be variable (e.g., bent).

According to an embodiment, the heat dissipation member 310 may be disposed in the inner space between the display 230, the first and second housings 210 and 220, and the first and second waterproof members 361 and 362. The inner space may be about 200µm thick. Accordingly, the heat dissipation member 310 disposed in the inner space may have a thickness of 200 µm or less, and may be, e.g., about 50 µm to 120 µm thick. The heat dissipation member 310 is a structure in which the thermally conductive sheet 311 and the metal sheet 312 are laminated, and the thermally conductive sheet 311 may be about 27 to 80 µm, and the metal sheet 312 may be about 10 to 50 µm thick. For example, the metal sheet 312 may be about 20 µm to 40 µm thick.

According to an embodiment, the heat dissipation member 310 may be fixed to the first housing 210 or the second housing 220 by the adhesive sheet 320. When the printed circuit board 260 and the heat source 330 disposed on the printed circuit board 260 are positioned in the first housing 210, the adhesive sheet 320 may adhere the first housing 210 to at least a portion of the first area S1 of the heat dissipation member 310. For example, the heat dissipation member 310 may be in a state in which the metal sheet 312 is laminated to one surface (e.g., one surface facing away from the display 230) of the thermally conductive sheet 311 and the thermally conductive sheet 311, and one area of the metal sheet 312 may be adhered to the first housing 210 by the adhesive sheet 320. As another example, the heat conductive sheet 311 may be laminated to the metal sheet 312 and one surface (e.g., one surface facing away from the display 230) of the metal sheet 312, and one area of the heat conductive sheet 311 may be adhered to the first housing 210 by the adhesive sheet 320. As described above, the configuration in which the adhesive sheet 320 is disposed in the first housing 210 is described, but is not limited thereto. When the main heat source is disposed in the second housing 220, the adhesive sheet 320 may be disposed in the second housing 220.

According to an embodiment, in the unfolded state (e.g., see FIG. 5) of the electronic device 101, the first area S1 of the heat dissipation member 310 may remain fixed to the first housing 210 by the adhesive sheet 320. As the heat provided from the heat source 330 is transferred to the second area S2 along the first area S1 of the heat dissipation member 310, the heat may be entirely diffused through the display 230 and/or the first and second housings 210 and 220. In the intermediate state (e.g., see FIG. 6) of the electronic device 101, the first area S1 of the heat dissipation member 310 may remain fixed to the first housing 210 by the adhesive sheet 320, and the second area S2 of the heat dissipation member 310 without the adhesive sheet 320 may slide by a first distance d1 in a direction away from the second waterproof member 362. The area near the boundary between the first area S1 and/or the second area S2 of the heat dissipation member 310 may be bent together as the display 230 is bent. As the heat provided from the heat source 330 is transferred to the second area S2 along the first area S1 of the heat dissipation member 310, the heat may be entirely diffused through the display 230 and/or the first and second housings 210 and 220. In the folded state (e.g., see FIG. 7) of the electronic device 101, the first area S1 of the heat dissipation member 310 may remain fixed to the first housing 210 by the adhesive sheet 320, and the second area S2 of the heat dissipation member 310 without the adhesive sheet 320 may slide by a second distance d2 away from the second waterproof member 362. The second distance d2 may be larger than the first distance d1. The area near the boundary between the first area S1 and/or the second area S2 of the heat dissipation member 310 may be bent together as the display 230 is bent. As the heat provided from the heat source 330 is transferred to the second area S2 along the first area S1 of the heat dissipation member 310, the heat may be entirely diffused through the display 230 and/or the first and second housings 210 and 220.

According to an embodiment, the electronic device 101 may include a first hinge plate 351 and a second hinge plate 352 connected through at least one hinge structure 280. According to an embodiment, the first hinge plate 351 may form the same plane as the first housing 210 in the unfolded state, the intermediate state, and the folded state of the electronic device 101, and the second hinge plate 352 may form the same plane as the second housing 220 in the unfolded state of the electronic device 101. According to an embodiment, the adhesive sheet 320 may extend from the first housing 210 to the first hinge plate 351. As the adhesive sheet 320 adheres the heat dissipation member 310 to the first housing 210 and the first hinge plate 351 by the extended length, the adhesive sheet 320 may fix a portion of the first area S1 of the heat dissipation member 310. A portion of the fixed heat dissipation member 310 may maintain a flat shape at all times, and the remaining portion of the heat dissipation member 310 may be bent or slid according to the intermediate state and the folded state of the electronic device 101.

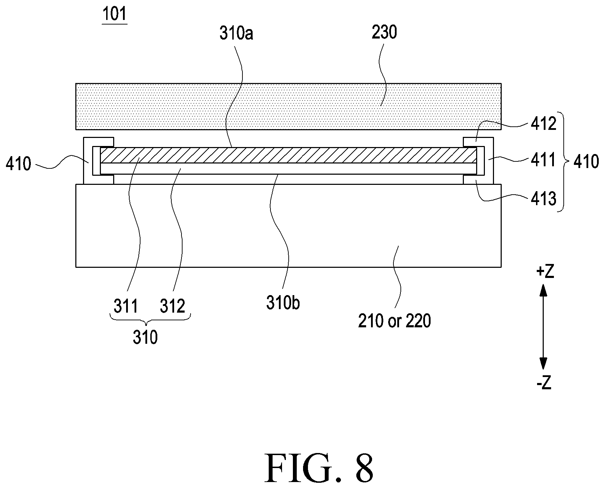

FIG. 8 is a view illustrating a guide structure for sliding a heat dissipation member according to an embodiment of the disclosure.

FIG. 8 is a schematic view taken along C-C of FIG. 2.

In an embodiment, the electronic device 101 may include a first housing 210, a second housing 220, a display 230, a heat dissipation member 310, and a guide structure 410. The configuration of the first housing 210, the second housing 220, the display 230, and the heat dissipation member 310 of FIG. 8 may be identical in whole or part to the configuration of the first housing 210, the second housing 220, the display 230, and the heat dissipation member 310 of FIGS. 5, 6, and 7. The structure of FIG. 8 may be selectively coupled to the structure of FIGS. 5, 6, and 7.

According to an embodiment, the display 230 (e.g., a flexible display) may be configured to be unfolded or folded (e.g., bent or rolled) based on the relative movement of the first housing 210 or the second housing 220.

According to an embodiment, the heat dissipation member 310 may include a first area S1 disposed on the first housing 210, and a second area S2 extending from the first area S1 and disposed on the second housing 220. For example, when viewed toward the display 230, the first area S1 of the heat dissipation member 310 may overlap a portion of the first housing 210, and the second area S2 may overlap a portion of the second housing 220.

According to an embodiment, a partial area of the heat dissipation member 310 may remain fixed to the first housing 210 or the second housing 220, and another partial area may be formed to be slidable. For example, at least a portion of the first area S1 of the heat dissipation member 310 may be attached onto the first housing 210, and may be fixed when the electronic device 101 operates from the unfolded state to the folded state. The second area S2 of the heat dissipation member 310 may be disposed over the second housing 220, but may not be attached thereto, and thus, may slide with respect to at least a portion of the fixed first area S1 when the electronic device 101 operates from the unfolded state to the folded state.

According to an embodiment, the guide structure 410 may be disposed on the second housing 220 to guide the sliding movement of the second area S2 of the heat dissipation member 310. The guide structure 410 may include a guide portion 411 extending in a sliding direction of the heat dissipation member 310, and anti-escape portions 412 and 413 extending in a direction perpendicular to the guide portion 411. For example, the guide portion 411 of the guide structure 410 may extend along the sliding movement of the heat dissipation member 310 to guide the movement path of the heat dissipation member 310. The anti-escape portions 412 and 413 of the guide structure 410 may be formed to support the upper surface 310a and the lower surface 310b of the heat dissipation member 310 so that the heat dissipation member 310 does not move in a direction (e.g., the +Z-axis direction and/or the -Z-axis direction) other than the sliding direction. Two guide structures 410 may be formed at two opposite ends of the heat dissipation member 310. As illustrated, when viewed in a cross section, the guide structure 410 may have a shape of '[' and ']' capable of fitting (or coupling) near two opposite sides of the heat dissipation member 310.

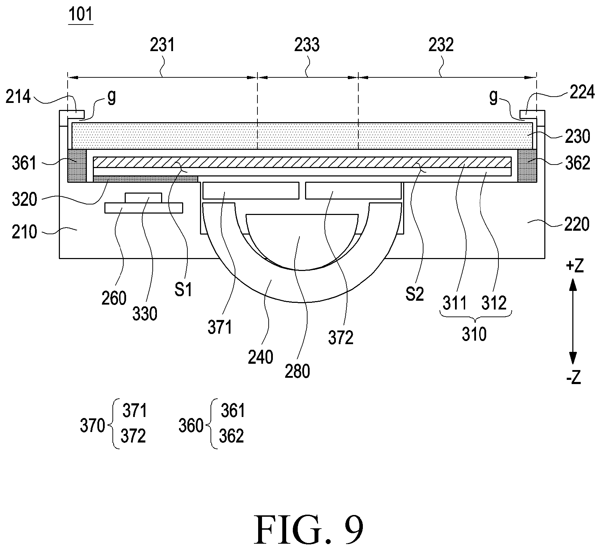

FIG. 9 is a cross-sectional view taken along a length direction in an unfolded state of an electronic device according to an embodiment of the disclosure.

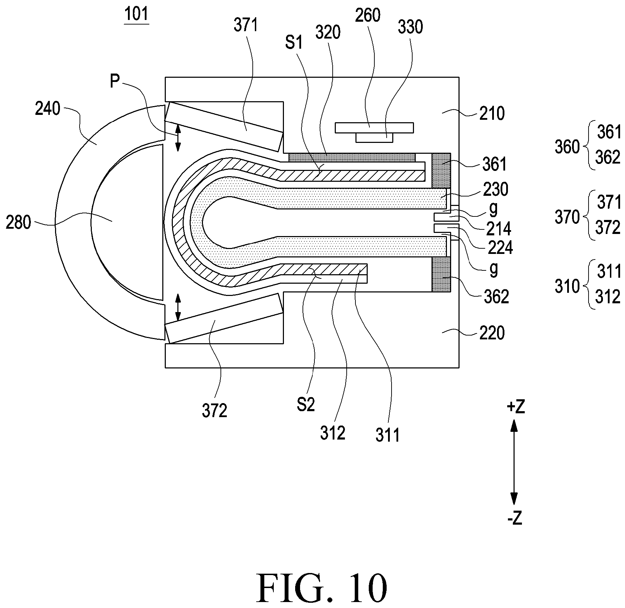

FIG. 10 is a cross-sectional view taken along a length direction in a folded state of an electronic device according to an embodiment of the disclosure.

FIG. 9 is a schematic view taken along line B-B' of FIG. 2 (or line B-B' of FIG. 11), and FIG. 10 is a schematic cross-sectional view taken along line D-D' of FIG. 3.

In an embodiment, the electronic device 101 may include a first housing 210, a second housing 220, a hinge structure 280, a display 230, a printed circuit board 260, and a heat dissipation member 310. The configuration of the first housing 210, the second housing 220, the hinge structure 280, the display 230, and the printed circuit board 260 of FIGS. 9, and 10 may be identical in whole or part to the configuration of the first housing 210, the second housing 220, the hinge structure 280, the display 230, and the first printed circuit board 260 of FIGS. 5, 6, and 7. The structure of FIGS. 9, and 10 may be selectively coupled to the structure of FIGS. 5, 6, 7, and 8.

According to an embodiment, the display 230 (e.g., a flexible display) may be configured to be unfolded or folded (e.g., bent or rolled) based on the relative movement of the first housing 210 or the second housing 220, and may include a first display area 231 connected to the first housing 210, a second display area 232 connected to the second housing 220, and a folding area 233 connecting the first display area 231 and the second display area 232.

According to an embodiment, the heat dissipation member 310 may include a first area S1 disposed adjacent to the heat source 330 disposed on the printed circuit board 260 and a second area S2 extending from the first area S1. The first area S1 of the heat dissipation member 310 may overlap a portion of the first display area 231 and/or the folding area 233 of the display 230, and the second area S2 of the heat dissipation member 310 may overlap the second display area 232 and/or the folding area 233 of the display 230. As the heat generated from the heat source 330 is transferred to the first area S1 of the heat dissipation member 310 and then diffused to the second area S2, the heat may not be concentrated in a certain portion (e.g., the first display area 231) of the display 230, but the heat may be diffused throughout the display 230.

According to an embodiment, a partial area of the heat dissipation member 310 may remain fixed to the first housing 210 or the second housing 220, and another partial area may be formed to be slidable. For example, at least a portion of the first area S1 of the heat dissipation member 310 may be attached onto the first housing 210, and may be fixed when the electronic device 101 operates from the unfolded state to the folded state. The second area S2 of the heat dissipation member 310 may be disposed over the second housing 220, but may not be attached thereto, and thus, may slide with respect to at least a portion of the fixed first area S1 when the electronic device 101 operates from the unfolded state to the folded state.

According to an embodiment, the heat dissipation member 310 may be disposed to substantially face a substantial portion of the display 230. The first display area 231 of the display 230 may face the first housing 210, and the edge portion of the first display area 231 may seal the gap formed by the first housing 210 and the first display area 231 by the first waterproof member 361. The second display area 232 of the display 230 may face the second housing 220, and the edge portion of the second display area 232 may seal the gap formed by the second housing 220 and the first display area 231 by the second waterproof member 362. The heat dissipation member 310 may be disposed in an inner space surrounded by the display 230, the first and second housings 210 and 220, and the first and second waterproof members 361 and 362.

According to an embodiment, the heat dissipation member 310 may be fixed to the first housing 210 or the second housing 220 by the adhesive sheet 320. When the printed circuit board 260 and the heat source 330 disposed on the printed circuit board 260 are positioned in the first housing 210, the adhesive sheet 320 may adhere the first housing 210 to at least a portion of the first area S1 of the heat dissipation member 310.

According to an embodiment, the electronic device 101 may include a first hinge plate 371 and a second hinge plate 372 connected through at least one hinge structure 280. According to an embodiment, the first hinge plate 371 may form the same plane as the first housing 210 in the unfolded state of the electronic device 101, and the second hinge plate 372 may form the same plane as the second housing 220 in the unfolded state of the electronic device 101.

According to an embodiment, in the folded state of the electronic device 101, the display 230 may be deformed into a shape having a designated curved surface (e.g., a "U" shape or a water drop shape) and may be accommodated in the inner space of the electronic device 101 through the at least one hinge structure 280. According to an embodiment, in the folded state of the electronic device 101, the first hinge plate 371 and the second hinge plate 372 may be moved (e.g., in the P direction) to support at least a portion of the folding area 233, which is deformed to have a curved surface of the display 230. According to an embodiment, the first housing 210 and the second housing 220 may move to support substantially non-deformed flat areas (e.g., the first display area 231 and the second display area 232) of the display 230 in the folded state of the electronic device 101. According to an embodiment, the first hinge plate 371 may not form the same plane as the first housing 210 in the folded state of the electronic device 101. The first hinge plate 371 may form a surface inclined at a designated angle with respect to the first display area 231. The second hinge plate 372 may also not form the same plane as the second housing 220. The second hinge plate 372 may form a surface inclined at a designated angle with respect to the second display area 232.

According to an embodiment, the adhesive sheet 320 may be disposed on the first housing 210 and may not be disposed on the first hinge plate 371. When the electronic device 101 operates from the unfolded state to the folded state, the first hinge plate 371 may provide a surface inclined at a designated angle, and thus may not provide an area in which the adhesive sheet 320 is disposed. Accordingly, the adhesive sheet 320 may fix only a portion of the first area S1 of the heat dissipation member 310 and the first housing 210. The fixed portion of the heat dissipation member 310 may maintain a flat shape at all times, and the remaining portion of the heat dissipation member 310 may be bent or slid according to the intermediate state and the folded state of the electronic device 101.

FIG. 11 is a see-through view illustrating a disposition of a heat dissipation member and a heat diffusion direction in an unfolded state of an electronic device according to an embodiment of the disclosure.

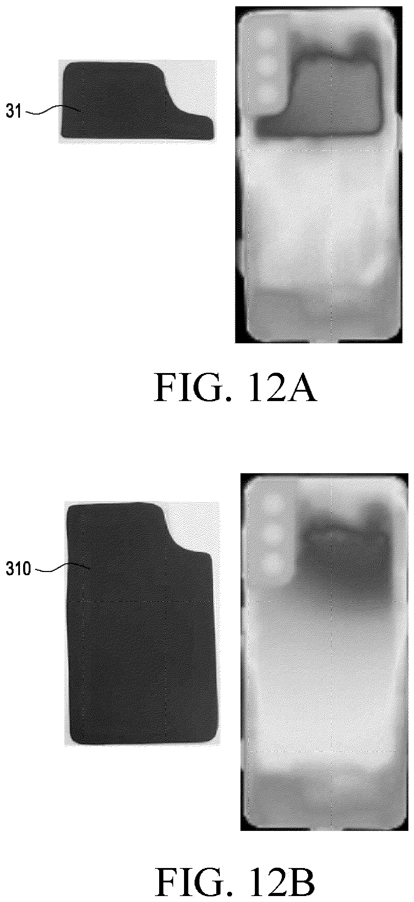

FIG. 12A is a view illustrating the degree of heat diffusion when a heat dissipation member is disposed in a first housing according to a comparative embodiment.

FIG. 12B is a view illustrating the degree of heat diffusion when a heat dissipation member extends to be disposed in a first housing and a second housing according to an embodiment of the disclosure.

In an embodiment, the electronic device 101 may include a first housing 210, a second housing 220, a printed circuit board 260 on which a heat source 330 is disposed, a waterproof member 360, and a heat dissipation member 310. The configuration of the first housing 210, the second housing 220, the printed circuit board 260 on which the heat source 330 is disposed, the waterproof member 360, and the heat dissipation member 310 of FIGS. 11 and 12B may be identical in whole or part to the configuration of the first housing 210, the second housing 220, the printed circuit board 260 on which the heat source 330 is disposed, the waterproof member 360, and the heat dissipation member 310 of FIGS. 5 to 10. The structure of FIGS. 11 and 12B may be selectively combinable with the structures of FIGS. 5 to 10.

According to an embodiment, the heat dissipation member 310 may include a first area S1 disposed on the first housing 210, and a second area S2 extending from the first area S1 and disposed on the second housing 220. For example, when viewed toward the display 230, the first area S1 of the heat dissipation member 310 may overlap a portion of the first housing 210, and the second area S2 may overlap a portion of the second housing 220.

According to an embodiment, in the unfolded state, the intermediate state, and the folded state of the electronic device 101, the heat dissipation member 310 may be disposed in most of the area of the electronic device 101. As the heat provided from the heat source 330 is transferred to the second area S2 along the first area S1 of the heat dissipation member 310, the heat may be entirely diffused through the display and/or the first and second housings 210 and 220.

Table 1 below compares the heat dissipation performance of the heat dissipation member 31 disposed only in the first housing 210 with the heat dissipation performance of the heat dissipation member 310 disposed across the first housing 210 and the second housing 220.

**[Table 1]**

| Heat dissipation performance | Temperature |
|---|---|
| heat dissipation member of FIG. 12A | 46.5(-) |
| heat dissipation member of FIG. 12B (Max. performance) | 44.3(2.2↓) |

Referring to Table 1 and FIG. 12A, when the heat dissipation member 31 disposed only in the first housing 210 is disposed, it may be identified that heat is concentrated around the heat source 330. As heat is concentrated in a specific area, the increased heat temperature may affect the specific area and components disposed adjacent thereto, thereby deteriorating the overall performance of the electronic device.

Referring to Table 1 and FIG. 12B, the heat dissipation member 310 may be disposed to cover the first housing 210 and the second housing 220, thereby effectively diffusing heat to the entire electronic device 101. For example, compared with the heat dissipation member 31 of FIG. 12A, the heat dissipation member 310 of FIG. 12B according to an embodiment may decrease the maximum temperature by about 2.2 degrees or more.

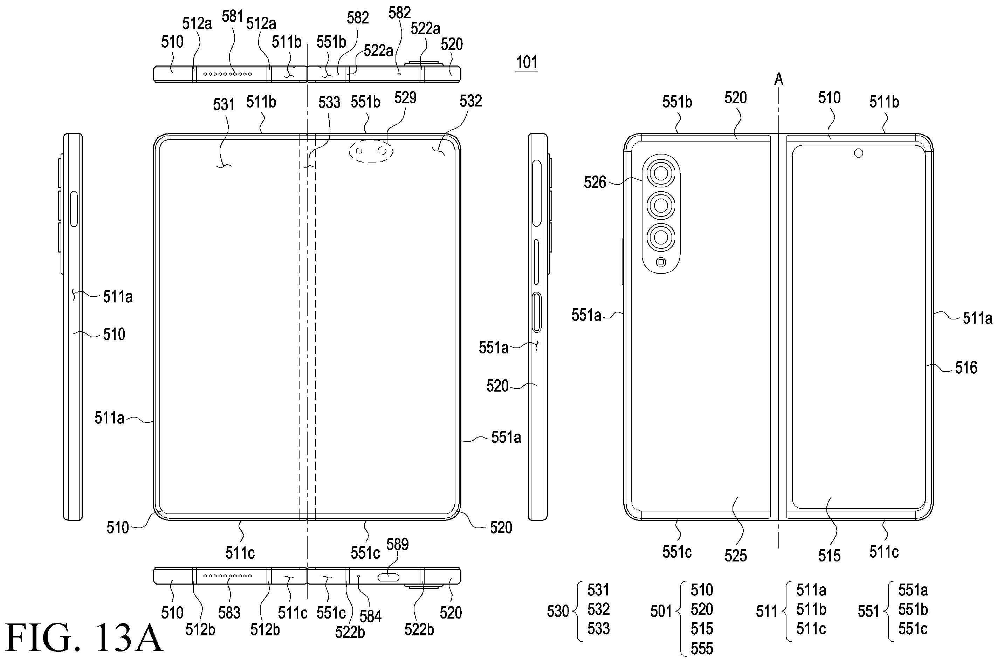

FIG. 13A is a view illustrating an unfolded state of an electronic device according to an embodiment of the disclosure.

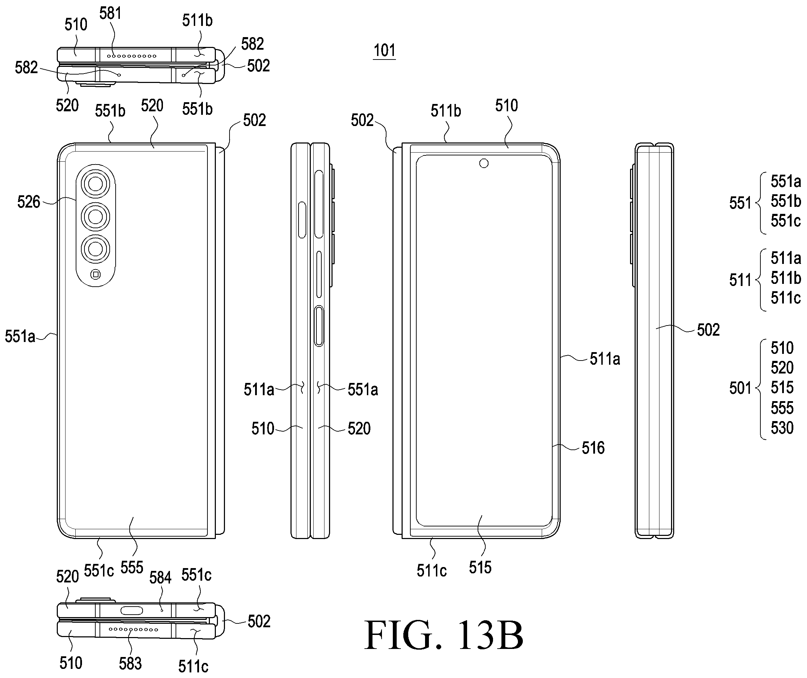

FIG. 13B is a view illustrating a folded state of an electronic device according to an embodiment of the disclosure.

FIG. 13A is a view illustrating an unfolded state among folding states of an electronic device (or a foldable electronic device) according to an embodiment. FIG. 13B is a view illustrating a folded state of an electronic device (or a foldable electronic device) according to an embodiment. The electronic device 101 of FIGS. 13A and 13B is an example of the electronic device 101 illustrated in FIG. 1, and may be a foldable or bendable electronic device.

The embodiments of FIGS. 13A and 13B may be combined with the embodiment of FIG. 1 or the embodiments of FIGS. 5 to 10. For example, FIG. 5 is a schematic view taken along line E-E' of FIG. 13A, and FIG. 7 is a schematic view taken along line F-F' of FIG. 13B.

The configuration of the electronic device 101 of FIGS. 13A and 13B may be identical in whole or part to the configuration of the electronic device 101 of FIG. 1.

Referring to FIGS. 13A and 13B, in an embodiment, the electronic device 101 may include a foldable housing 501 and a flexible or foldable display 530 (hereinafter, simply referred to as a "flexible display" 550) (e.g., the display module 160 of FIG. 1) disposed in a space formed by the foldable housing 501. According to an embodiment, the surface where the flexible display 530 is disposed (or the surface where the flexible display 530 is viewed from the outside of the electronic device 101) may be defined as the front surface of the electronic device 101. The opposite surface of the front surface may be defined as a rear surface of the electronic device 101. The surface surrounding the space between the front and back surfaces may be defined as a side surface of the electronic device 101.

According to an embodiment, the foldable housing 501 may include a first housing 510, a second housing 520 including a sensor area 529, a first rear cover 515, a second rear cover 525, and a hinge assembly 502. According to an embodiment, the hinge assembly 502 may include a hinge cover covering a foldable portion of the foldable housing 501. The foldable housing 501 of the electronic device 101 are not limited to the shape and coupling shown in FIGS. 13A and 13B but may rather be implemented in other shapes or via a combination and/or coupling of other components. For example, in an embodiment, the first housing 510 and the first rear cover 515 may be integrally formed with each other, and the second housing 520 and the second rear cover 525 may be integrally formed with each other.

According to an embodiment, an illuminance sensor and an image sensor may be disposed in the sensor area 522. The illuminance sensor may detect the amount of light around the electronic device 101. The image sensor may convert the light incident through the camera lens into a digital signal. The illuminance sensor and the image sensor may be visually exposed to the flexible display 530. According to an embodiment, the illuminance sensor and the image sensor may not be visually exposed. For example, the camera may be configured as an under display camera (UDC). Pixels in one area of the flexible display 530 corresponding to the location of the UDC may be configured to differ from pixels in other areas, so that the image sensor and/or camera may not be visually exposed.

According to an embodiment, the first housing 510 may be connected to the hinge assembly 502 and may include a first front surface facing in a first direction and a first rear surface facing in a direction opposite to the first direction. The second housing 520 may be connected to the hinge assembly 502 and may include a second front surface facing in a second direction and a second rear surface facing in a direction opposite to the second direction. The first housing 510 may rotate about the hinge assembly 502 with respect to the second housing 520. The second housing 520 may rotate about the hinge assembly 502 with respect to the first housing 510. The electronic device 101 may transform to a folded status or an unfolded status.

According to an embodiment, the first housing 510 may include a 1-1th side surface 511a disposed to be spaced apart from and in parallel to the folding axis A of the hinge assembly 502 between the first front surface and the first rear surface, and the second housing 520 may include a 2-1th side surface 521a disposed to be spaced apart from and in parallel to the folding axis A of the hinge assembly 502 between the second front surface and the second rear surface. Further, the first housing 510 may include a 1-2th side surface 511b perpendicular to the 1-1th side surface 511a and having an end connected with the 1-1th side surface 511a and another end connected with the hinge assembly 502 and a 1-3th side surface 511c perpendicular to the 1-1th side surface 511a and having an end connected with the 1-1th side surface 511a and another end connected with the hinge assembly 502 and spaced apart from and in parallel to the 1-2th side surface 511b. The second housing 520 may include a 2-2th side surface 521b perpendicular to the 2-1th side surface 521a and having an end connected with the 2-1th side surface 521a and another end connected with the hinge assembly 502 and a 2-3th side surface 521c perpendicular to the 2-1th side surface 521a and having an end connected with the 2-1th side surface 521a and another end connected with the hinge assembly 502 and spaced apart from and in parallel to the 2-2th side surface 521b. When the first housing 510 is folded about the hinge assembly 502 with respect to the second housing 520 (e.g., FIG. 3), the 1-1th side surface 511a may approach the 2-1th side surface 521a and, when the first housing 510 is unfolded about the hinge assembly 502 with respect to the second housing 520 (e.g., FIG. 2), the 1-1th side surface 511a may move away from the 2-1th side surface 521a.

According to an embodiment, in the fully folded state of the electronic device 101, the first front surface may face the second front surface and, in the fully unfolded state, the first direction may be identical to the second direction. In the fully unfolded state, the distance between the 1-1th side surface 511a and the 2-1th side surface 521a may be the largest.

According to an embodiment, the first housing 510 and the second housing 520 are disposed on two opposite sides of the folding axis A and be overall symmetrical in shape with respect to the folding axis A. As described below, the angle or distance between the first housing 510 and the second housing 520 may be varied depending on whether the electronic device 101 is in the unfolded state, the folded state, or the partially unfolded (or partially folded) intermediate state.

According to an embodiment, as shown in FIG. 13A, the first housing 510 and the second housing 520 together may form a recess to accommodate the flexible display 530. According to an embodiment, at least a portion of the first housing 510 and the second housing 520 may be formed of a metallic material or a non-metallic material having rigidity of a selected size for supporting the flexible display 530. At least a portion formed of metal may provide a ground plane of the electronic device 101 and may be electrically connected with a ground line formed on the printed circuit board disposed in the foldable housing 501.

According to an embodiment, a protection member may be disposed outside the flexible display 530. The protection member may be formed integrally with the side surface of the foldable housing 501 or as a separate structure. The flexible display 530 may not adhere to the side surface of the foldable housing 501 and/or the protection member. A gap may be formed between the flexible display 530 and the protection member. The protection member may be configured to cover the internal configuration of the electronic device 101 from the outside or to protect the internal configuration of the electronic device 101 from external impact. According to an embodiment, the protection member may be configured to cover the line disposed on the flexible display 530 from the outside or to protect it from an external impact.

According to an embodiment, the first rear cover 515 may be disposed on one side of the folding axis A on the rear surface of the electronic device 101 and have, e.g., a substantially rectangular periphery which may be surrounded by the first housing 510. Similarly, the second rear cover 525 may be disposed on the opposite side of the folding axis A on the rear surface of the electronic device 101 and its periphery may be surrounded by the second housing 520.

According to an embodiment, the first rear cover 515 and the second rear cover 525 may be substantially symmetrical in shape with respect to the folding axis A. However, the first rear cover 515 and the second rear cover 525 are not necessarily symmetrical in shape. In an embodiment, the electronic device 101 may include the first rear cover 515 and the second rear cover 525 in various shapes. In an embodiment, the first rear cover 515 may be integrally formed with the first housing 510, and the second rear cover 525 may be integrally formed with the second housing 520.

According to an embodiment, the first rear cover 515, the second rear cover 525, the first housing 510, and the second housing 520 may form a space where various components (e.g., a printed circuit board or battery) of the electronic device 101 may be disposed. According to an embodiment, one or more components may be disposed or visually exposed on the rear surface of the electronic device 101. For example, at least a portion of a sub display may be visually exposed through a first rear surface area 516 of the first rear cover 515. For example, one or more components or sensors may be visually exposed through a second rear surface area 526 of the second rear cover 525. In an embodiment, the sensor may include a proximity sensor and/or a rear camera.

According to an embodiment, the front camera disposed on the front surface (e.g., the second front surface) of the electronic device 101 or the rear camera exposed through the second rear area 526 of the second rear cover 525 may include one or more lenses, an image sensor, and/or an image signal processor. The flash may include, e.g., a light emitting diode (LED) or a xenon lamp. In an embodiment, two or more lenses (an infrared (IR) camera, a wide-angle lens, and a telescopic lens) and image sensors may be disposed on one surface of the electronic device 101.

Referring to FIG. 13B, the hinge cover (e.g., the hinge cover 532 of FIG. 5) included in the hinge assembly 502 may be disposed between the first housing 510 and the second housing 520 to hide the internal components (e.g., the hinge structure). According to an embodiment, the hinge assembly 502 may be hidden by a portion of the first housing 510 and second housing 520 or be exposed to the outside depending on the state (the unfolded state, intermediate state, or folded state) of the electronic device 101.

According to an embodiment of the present invention, as shown in FIG. 13A, in the unfolded state (e.g., a fully unfolded state) of the electronic device 101, the hinge assembly 502 may be hidden not to be exposed by the first housing 510 and the second housing 520. According to an embodiment, as shown in FIG. 13B, in the folded state (e.g., a fully folded state) of the electronic device 101, the hinge assembly 502 may be exposed to the outside between the first housing 510 and the second housing 520. As an embodiment, in the intermediate state in which the first housing 510 and the second housing 520 are folded with a certain angle, the hinge assembly 502 may be partially exposed to the outside between the first housing 510 and the second housing 520. However, in this case, the exposed area may be smaller than that in the completely folded state. In an embodiment, the hinge assembly 502 may include a curved surface.

In an embodiment, the flexible display 530 may be disposed in a space formed by the foldable housing 501. For example, the flexible display 530 may be seated in a recess formed by the foldable housing 501 and may be seen from the outside through the front surface (e.g., the first front surface and/or the second front surface) of the electronic device 101. According to an embodiment, the flexible display 530 may constitute most of the front surface (e.g., the first front surface and/or the second front surface) of the electronic device 101. Accordingly, the front surface (e.g., the first front surface and/or the second front surface) of the electronic device 101 may include the flexible display 530 and a partial area of the first housing 510 and a partial area of the second housing 520 adjacent to the flexible display 530. The rear surface (e.g., the first rear surface and/or second rear surface) of the electronic device 101 may include the first rear cover 515, a partial area of the first housing 510 adjacent to the first rear cover 515, the second rear cover 525, and a partial area of the second housing 520 adjacent to the second rear cover 525.

According to an embodiment, the flexible display 530 may refer to a display in which at least a partial area thereof may be deformed into a flat surface or a curved surface. According to an embodiment, the flexible display 530 may include a folding area 533, a first display area 531 disposed on one side of the folding area 533 (e.g., the left side of the folding area 533 of FIG. 2), and a second display area 532 disposed on the opposite side of the folding area 533 (e.g., the right side of the folding area 1203 of FIG. 2).

According to an embodiment, the first display area 531 may be disposed on the first housing 510, and the second display area 532 may be disposed on the second housing 520. According to an embodiment, the folding area 533 may connect the first display area 531 and the second display area 532, and may be disposed on the hinge assembly 502.

The segmentation of the flexible display 530 as shown in FIG. 2 is merely an example, and the display 530 may be divided into a plurality of (e.g., four or more, or two) areas depending on the structure or function of the display 200. For example, in the embodiment illustrated in FIG. 2, the area of the flexible display 530 may be divided by the folding area 533 extending parallel to the folding axis A, but the area of the flexible display 530 may be divided by another folding axis (e.g., a folding axis parallel to the width direction of the electronic device).

According to an embodiment, the flexible display 530 may be coupled to or disposed adjacent to a touch panel having a pressure sensor capable of measuring the intensity (pressure) of touch or a touch sensing circuit. For example, the flexible display 530 may be disposed adjacent to or coupled with an electromagnetic induction panel, as an example of the touch pane, which detects a stylus pen of an electromagnetic resonance (EMR) type.

According to an embodiment, the first display area 531 and the second display area 532 may be overall symmetrical in shape with respect to the folding area 533.

Described below are the operation of the first housing 510 and the second housing 520 and each area of the flexible display 530 depending on the state (e.g., the folded state, unfolded state, or intermediate state) of the electronic device 101.

According to an embodiment, when the electronic device 101 is in the unfolded state (e.g., FIG. 13A), the first housing 510 and the second housing 520 may be disposed to face in the same direction while forming an angle of 180 degrees. The surface of the first display area 531 and the surface of the second display area 532 of the flexible display 530 may be angled at 180 degrees therebetween while facing in the same direction (e.g., forward of the front surface of the electronic device). In this case, the folding area 533 may form the same plane with the first display area 531 and the second display area 532.

According to an embodiment, when the electronic device 101 is in the folded state (e.g., FIG. 13B), the first housing 510 and the second housing 520 may be disposed to face each other. The surface of the first display area 531 and the surface of the second display area 532 of the flexible display 530 may face each other while forming a narrow angle (e.g., between 0 degrees and 10 degrees). At least a portion of the folding area 533 may be formed as a curve having a predetermined curvature.

According to an embodiment, when the electronic device 101 is in the intermediate state, the first housing 510 and the second housing 520 may be disposed at a certain angle. The surface of the first display area 531 and the surface of the second display area 532 of the flexible display 530 may form an angle larger than that in the folded state and smaller than that in the unfolded state. The folding area 533 may at least partially have a curved surface with a predetermined curvature and, in this case, the curvature may be smaller than that when it is in the folded state.

According to an embodiment, the first housing 510 may include first housing holes 581 and 283. According to an embodiment, the first housing holes 581 and **283** may include a 1-1th housing hole 581 formed in the 1-2th side surface 511b of the first housing 510 and a 1-2th housing hole 583 formed in the 1-3th side surface 511c of the first housing 510.

According to an embodiment, the 1-2th side surface 511b of the first housing 510 may include a 1-1th segmenter 512a formed of a non-metallic material. According to an embodiment, a pair of 1-1th segmenters 512a spaced apart from each other may be provided. According to an embodiment, the 1-1th housing hole 581 may be formed between the pair of 1-1th segmenters 512a.

According to an embodiment, the 1-3th side surface 511c of the first housing 510 may include a 1-2th segmenter 512b formed of a non-metallic material. According to an embodiment, a pair of 1-2th segmenters 512b spaced apart from each other may be provided. According to an embodiment, the 12th housing hole 583 may be formed between the pair of 1-2th segmenters 512b.

According to an embodiment, the number of at least one 1-1th housing hole 581 may be equal to the number of at least one 1-2th housing hole 583.

According to an embodiment, the 1-2th side surface 511b and the 1-3th side surface 511c may be disposed in parallel. According to an embodiment, the plurality of 1-1th housing holes 581 and the plurality of 1-2th housing holes 583 may be disposed to overlap each other with respect to the length direction (e.g., Y-axis direction) of the electronic device 101. For example, the plurality of 1-1th housing holes 581 may be disposed to correspond to the plurality of 1-2th housing holes 583, respectively, in the length direction (e.g., the Y axis direction of FIG. 5) of the electronic device 101.

According to an embodiment, the plurality of 1-1th housing holes 581 may be disposed on a straight line with respect to the width direction (e.g., the X axis direction) of the electronic device 101 (or first housing 510). According to an embodiment, the plurality of 1-2th housing holes 583 may be disposed on a straight line with respect to the width direction (e.g., the X axis direction) of the electronic device 101 (or first housing 510).

According to an embodiment, the second housing 520 may include second housing holes 582 and 284. According to an embodiment, the second housing holes 582 and **284** may include a 2-1th housing hole 582 formed in the 2-2th side surface 521b of the second housing 520 and a 2-2th housing hole 584 formed in the 2-3th side surface 521c of the second housing 520.

According to an embodiment, the 2-2th side surface 521b of the second housing 520 may include a 2-1th segmenter 522a formed of a non-metallic material. According to an embodiment, a pair of 2-1th segmenters 522a spaced apart from each other may be provided. According to an embodiment, a portion of the 2-1th housing hole 582 may be formed between the pair of 2-1th segmenters 522a, and the remaining portion of the 2-1th housing hole 582 may be formed between the folding axis A (or the hinge assembly 502) and any one of the 2-1th segmenters 522a.

According to an embodiment, the 2-3th side surface 521c of the second housing 520 may include a 2-2th segmenter 522b formed of a non-metallic material. According to an embodiment, a pair of 2-2th segmenters 522b spaced apart from each other may be provided. According to an embodiment, the 2-1th housing hole 582 may be formed between the pair of 2-2th segmenters 522b.

According to an embodiment, the 2-3th side surface 521c of the second housing 520 may include a connection terminal 589 (e.g., the connection terminal 178 of FIG. 1).

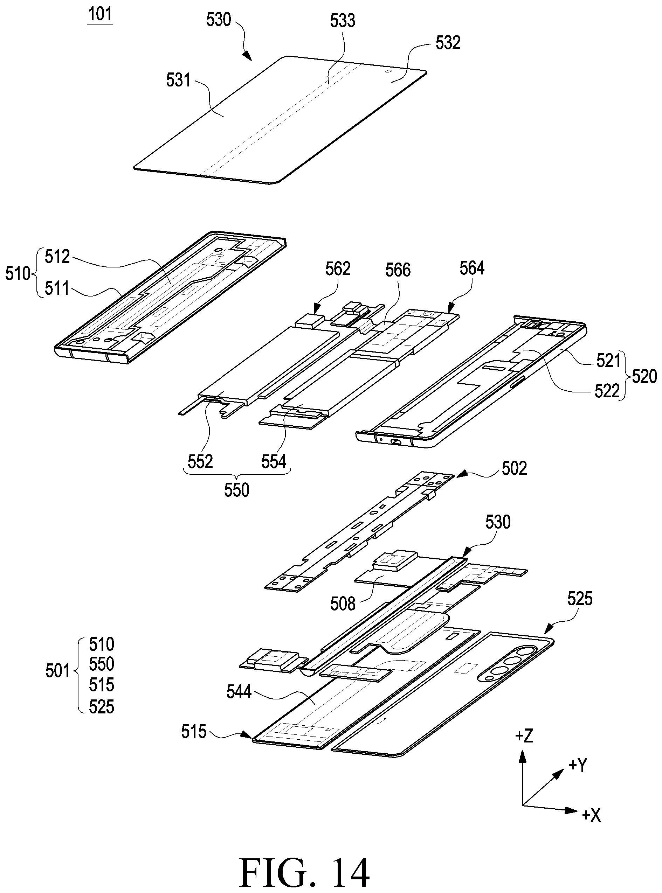

FIG. 14 is an exploded perspective view illustrating an electronic device according to an embodiment of the disclosure.

Referring to FIG. 14, an electronic device 101 may include a housing 501, a display 530, a hinge assembly 502, a battery 550, and a board unit 560. The housing 501 may include a first housing 510, a second housing 520, a first rear cover 515, and a second rear cover 525. The configuration of the first housing 510, the second housing 520, the hinge cover 540, the first rear cover 515, and the second rear cover 525 of FIG. 14 may be identical in whole or part to the configuration of the first housing 510, the second housing 520, the hinge cover 540, the first rear cover 515, and the second rear cover 525 of FIGS. 13A and 13B.

According to an embodiment, the first housing 510 and the second housing 520 may be assembled together to be coupled to two opposite sides of the hinge assembly 502. According to an embodiment, the first housing 510 may include a first supporting area 512 that may support the components (e.g., the first circuit board 562 and/or the first battery 552) of the electronic device 101 and a first sidewall 511 surrounding at least a portion of the first supporting area 512. The first sidewall 511 may include a first side surface (e.g., the first side surface 510c of FIG. 2) of the electronic device 101. According to an embodiment, the second housing 520 may include a second supporting area 522 that may support the components (e.g., the second circuit board 564 and/or the second battery 554) of the electronic device 101 and a second sidewall 521 surrounding at least a portion of the second supporting area 522. The second sidewall 521 may include a second side surface (e.g., the second side surface 520c of FIG. 2) of the electronic device 101.

According to an embodiment, the display 530 may include a first display area 531, a second display area 532, a folding area 533, and a sub display 544. The configuration of the first display area 531, the second display area 532, and the folding area 533 of FIG. 3 may be identical in whole or part to the configuration of the first display area 531, the second display area 532, and the folding area 533 of FIG. 1 and/or FIG. 2.

According to an embodiment, the sub display 544 may display screen in a different direction from the display areas 531 and 232. For example, the sub display **534** may output screen in a direction opposite to the first display area 531. According to an embodiment, the sub display **534** may be disposed on the first rear cover 515.

According to an embodiment, the battery 550 may include a first battery 552 disposed in the first housing 510 and a second battery 554 disposed in the second housing 520. According to an embodiment, the first battery 552 may be connected with the first circuit board 562, and the second battery 554 may be connected to the second circuit board 564. According to an embodiment, the battery 550 may supply power to at least one component of the electronic device 101. According to an embodiment, the battery 550 may include, for example, a primary cell which is not rechargeable, a secondary cell which is rechargeable, or a fuel cell.

According to an embodiment, the board unit 560 may include a first circuit board 562 disposed in the first housing 510 and a second circuit board 564 disposed in the second housing 520. According to an embodiment, the first circuit board 562 and the second circuit board 564 may be electrically connected by at least one flexible circuit board 566. According to an embodiment, at least a portion of the flexible circuit board 566 may be disposed across the hinge assembly 502. According to an embodiment, the first circuit board 562 and the second circuit board 564 may be disposed in a space formed by the first housing 510, the second housing 520, the first rear cover 515, and the second rear cover 525. Components for implementing various functions of the electronic device 101 may be disposed on the first circuit board 562 and the second circuit board 564.

According to an embodiment, the electronic device 101 may include speakers 508a and 208b. According to an embodiment, the speakers 508a and 2008b may convert the electric signal into sound. According to an embodiment, the speakers 508 and 208b may be disposed in a space formed by the first housing 510, the second housing 520, the first rear cover 515, and the second rear cover 525. According to an embodiment, the speakers 508a and 208b may include an upper speaker 508a positioned in an upper portion (+Y direction) of the electronic device 101 and a lower speaker 508b positioned in a lower portion (-Y direction) of the electronic device 101. In the disclosure, the speakers 508a and 208b are illustrated as positioned in one housing (e.g., the first housing 510 of FIG. 40, but this is an optional structure. For example, the speakers 508a and 208b may be positioned in at least one of the first housing 510 or the second housing 520. The configuration of the speakers 508a and 208b of FIG. 4 may be identical in whole or part to the configuration of the sound output module 155 of FIG. 1.

According to an embodiment, the electronic device 101 may include a rear member 570 (or rear case). According to an embodiment, the rear member 570 may be disposed in the housing 501 (e.g., the second housing 520). According to an embodiment, the rear member 570 may accommodate at least one antenna 575.

According to an embodiment, the electronic device 101 may include an antenna 575. The antennas 575a and 275b may include, e.g., an ultra-wide band (UWB) antenna 575a, a near-field communication (NFC) antenna, a wireless charging antenna, and/or a magnetic secure transmission (MST) antenna 575b. The antenna 575 may perform short-range communication with, e.g., an external device or may wirelessly transmit or receive power necessary for charging.

According to an embodiment, an antenna structure may be formed by a portion of the housing 501 or a combination thereof. For example, the antenna 575 may include a communication antenna 575c at least a portion of which is exposed to the outside and which forms at least a portion of the exterior of the electronic device 101. The communication antenna 575c may be used for communication (e.g., Wi-Fi) with an external electronic device. The communication antenna 575c may be connected to the upper portion 571a or the lower portion 571b of the rear member 570.

In the following detailed description, a configuration in which a pair of housings (or referred to as a 'housing') are coupled to be rotatable by a hinge assembly (or referred to as a 'hinge structure') is described as an example. However, it should be noted that the electronic device according to various embodiments of the disclosure is not limited thereto. For example, according to various embodiments, the electronic device may include three or more housings. In the embodiment disclosed below, a "pair of housings" may mean two rotatably-coupled housings among three or more housings.

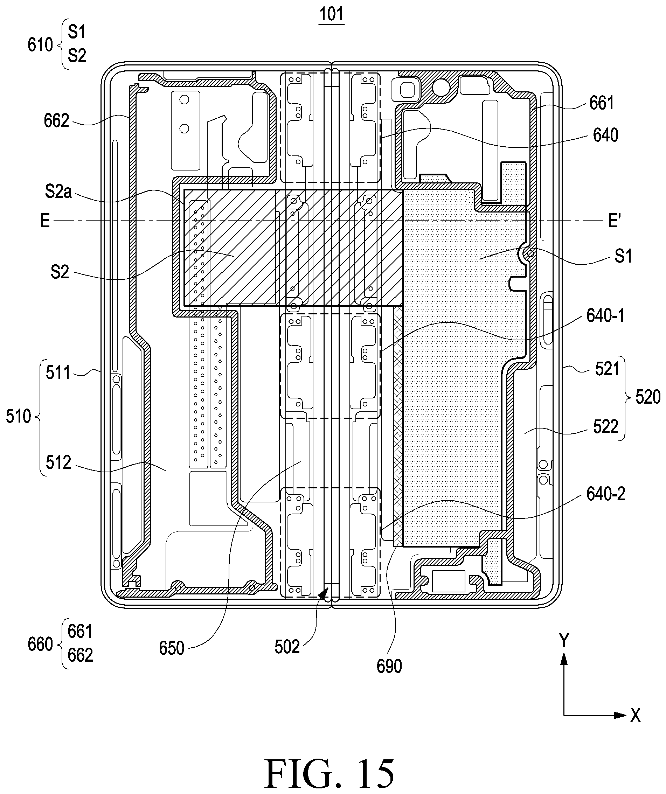

FIG. 15 is a view illustrating internal components in an unfolded state of an electronic device according to an embodiment of the disclosure.

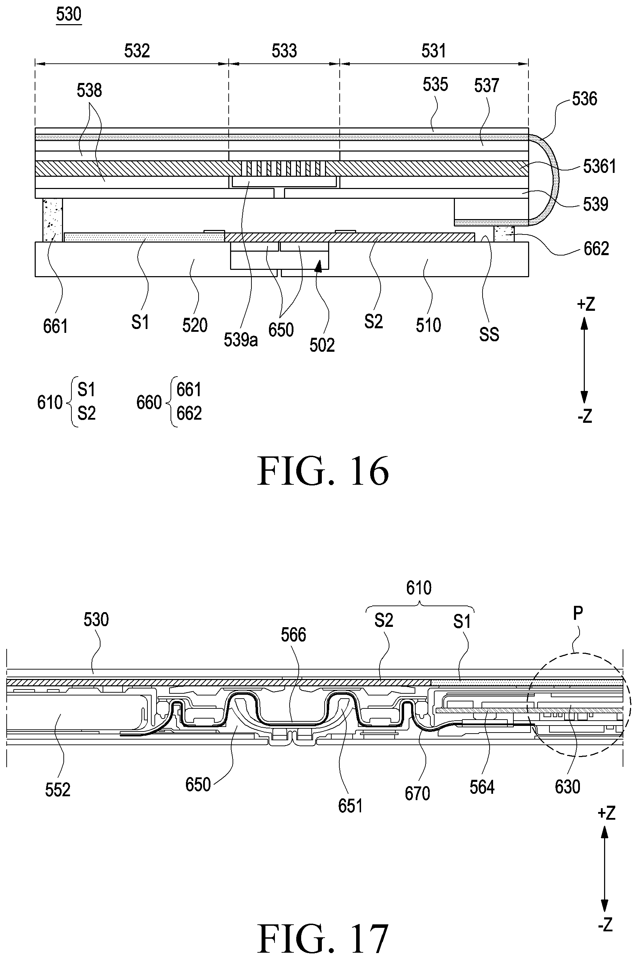

FIG. 16 is a cross-sectional view illustrating an arrangement relationship between a display and a housing, taken along a length direction (e.g., E-E' of FIG. 15) in an unfolded state of an electronic device according to an embodiment of the disclosure.

FIG. 17 is a cross-sectional view illustrating an electronic device, taken along a length direction (e.g., E-E' of FIG. 15) in an unfolded state of the electronic device according to an embodiment of the disclosure.

The electronic device 101 of FIGS. 15 and 17, as an example of the electronic device 101 shown in FIG. 1, may be a foldable or bendable electronic device.

According to an embodiment, the electronic device 101 may include a first housing 510, a second housing 520, a hinge device 640, a board unit 560, a display 530, a flexible circuit board 566, and a heat dissipation member 610. The configuration of the first housing 510, the second housing 520, the board unit 560, the hinge device 640, the display 530, and the flexible circuit board 566 of FIGS. 15, 16, and 17 may be identical in whole or part to the configuration of the first housing 510, the second housing 520, the board unit 560, the hinge assembly 502, the display 530, and the flexible circuit board 566 of FIGS. 13A to 14. The configuration of the heat dissipation member 610 of FIGS. 15, 16, and 17 may be identical in whole or part to the configuration of the heat dissipation member 310 of FIGS. 5 to 12B.

The structures of FIGS. 15, 16, and 17 may be selectively coupled to the structures of FIGS. 2 to 14 and/or FIGS. 18 to 30.

According to an embodiment, the electronic device 101 may include a hinge assembly (e.g., the hinge assembly 502 of FIG. 14) connected to the first housing 510 and the second housing 520 so that the first housing 510 and the second housing 520 are rotatable while the electronic device 101 is changed between the unfolded state and the folded state. The hinge assembly may include a hinge plate 650 and a hinge cover 651 for accommodating or supporting at least one hinge device 640, 640-1, or 640-2 and a portion of the hinge device 640, 640-1, or 640-2.

According to an embodiment, the electronic device 101 may include at least one hinge device 640, 640-1, or 640-2 (e.g., a hinge module or a hinge structure) connecting the first housing 510 and the second housing 520 under the display 530 (e.g., in the -Z-axis direction). For example, the at least one hinge device 640 or 640-1 may include a first hinge device 640 and a second hinge device 640-1 spaced apart from each other along the folding axis F. For example, the at least one hinge device 640, 640-1, or 640-2 may include a first hinge device 640, a second hinge device 640-1, and a third hinge device 640-2 spaced apart along the folding axis F. For example, the at least one hinge device 640, 640-1, or 640-2 may be supported by the first support area 512 extending from the first sidewall 511 to the inner space of the first housing 510 and the second support area 522 extending from the second sidewall 521 to the inner space of the second housing 520. For example, the at least one hinge device 640, 640-1, or 640-2 may be disposed between the first housing 510 and the second housing 520 so as not to be seen from the outside through the hinge cover 651 (e.g., the hinge housing).

According to an embodiment, the display 530 (e.g., a flexible display) may be configured to be unfolded or folded (e.g., bent or rolled) based on the relative movement of the first housing 510 or the second housing 520, and may include a first display area 531 connected to the first housing 510, a second display area 532 connected to the second housing 520, and a folding area 533 connecting the first display area 531 and the second display area 532.

According to an embodiment, the protective layer 535, the display panel 536, the transparent sheet 537, and the support plate 5361 may be stacked in the display 530 (e.g., flexible display). The protective layer 535, the display panel 536, and the transparent sheet 537 may include a flexible material. The protective layer 535 may be a glass. For example, the protective layer 535 may be thin film glass or ultra thin film glass. A partial area (e.g., a bending area) of the support plate 5361 corresponding to the folding area 533 of the display 530 may have a plurality of openings or recesses (e.g., a lattice pattern) formed therein so as to be easily folded or unfolded in response to the folding operation of the electronic device 101 (e.g., the display 530).

According to an embodiment, the display 530 may further include metal sheets 539 disposed under the support plate 5361 (e.g., in the -Z-axis direction). The metal sheets 539 may be separately disposed to correspond to the first display area 531 and the second display area 532. A digitizer may be disposed between the support plate 5361 and the metal sheet 539. The metal sheet 539 and/or a digitizer may be excluded according to design conditions. When the metal sheet 539 and/or the digitizer is excluded, the adhesive layer 538 disposed on the upper surface of the metal sheet 539 and the digitizer may also be excluded.

According to an embodiment, the display 530 may further include adhesive layers 538 disposed between the transparent sheet 537 and the support plate 5361 and/or between the support plate 5361 and the metal sheets 539. The adhesive layers 538 may be separately disposed to correspond to the first display area 531 and the second display area 532. The display 530 may include a polymer layer 539a, advantageous for bending, forming the same layer as the adhesive layers 538 and disposed between the adhesive layers 538. The polymer layer 539a may include a urethane material (e.g., thermoplastic poly urethane (TPU)), and may correspond to the folding area 533 of the display 530.

According to an embodiment, the electronic device 101 (e.g., the display 530) may be disposed on the first and second housings 510 and 520, and the waterproof member 660 may be disposed near the edge of the display 530 to prevent foreign substances (e.g., liquids) from entering the electronic device 101. The waterproof member 660 may include a second waterproof member 662 disposed along an edge of the first housing 510 (e.g., an edge of the first support area 512 and a vicinity of the first sidewall 511) and a first waterproof member 662 disposed along an edge of the second housing 520 (e.g., an edge of the second support area 522 and a vicinity of the second sidewall 521).

According to an embodiment, the first waterproof member 661 may seal the inflow passage formed between the second housing 520 and the display 530, thereby reducing or limiting the inflow of the foreign substance into the second housing 520. For example, a plurality of electrical components (e.g., a camera, a speaker, or a receiver) and a circuit board (e.g., a main circuit board) on which the electrical components are mounted may be positioned in the inner space of the second housing 520, and the first waterproof member 661 may be disposed in a closed curve shape to surround the plurality of electrical components. The first waterproof member 661 may seal between one area (e.g., the second display area 532) of the display 530 and the second housing 520 to prevent water from entering the electrical components. The first waterproof member 661 may have a tape shape.

According to an embodiment, the second waterproof member 662 may seal the inflow passage formed between the first housing 510 and the display 530, thereby reducing or limiting the inflow of the foreign substance into the first housing 510. For example, a plurality of electrical components (e.g., a camera, a speaker, or a receiver) and a circuit board (e.g., a sub circuit board) on which the electrical components are mounted may be positioned in the inner space of the first housing 510, and the second waterproof member 662 may be disposed in a closed curve shape to surround the plurality of electrical components. The second waterproof member 662 may seal between one area (e.g., the first display area 531) of the display 530 and the first housing 510 to prevent water from entering the electrical components. The second waterproof member 662 may have a tape shape.

According to an embodiment, the heat dissipation member 610 may include a first area S1, at least a portion of which is disposed on the second housing 520, and a second area S2 extending from the first area S1 and disposed on the first housing 510. For example, when viewed toward the display 530, the first area S1 of the heat dissipation member 610 may overlap a portion of the second housing 520, and the second area S2 may overlap a portion of the first housing 510. For example, the first area S1 of the heat dissipation member 610 may be fixed to the second housing 520 or at least one component accommodated in the second housing 520.

According to an embodiment, the heat dissipation member 610 may include a first area S1 disposed adjacent to the heat source 630 disposed on the board unit 560 and a second area S2 extending from the first area S1. The first area S1 of the heat dissipation member 610 may overlap a portion of the second display area 532 and/or the folding area 533 of the display 530, and the second area S2 of the heat dissipation member 610 may overlap the first display area 531 and/or the folding area 533 of the display 530. As heat generated from the heat source 630 is transferred to the first area S1 of the heat dissipation member 610 and then diffused to the second area S2, heat may not be concentrated in the housing (e.g., the first and second housings 510 and 520, or a predetermined portion (e.g., the second display area 532) of the display 530) but may be diffused throughout the housing.

According to an embodiment, a partial area of the heat dissipation member 610 may remain fixed to the first housing 510 or the second housing 520, and another partial area may be formed to be slidable. For example, at least a portion of the first area S1 of the heat dissipation member 610 may be attached to the second housing 520 (or at least one component accommodated in the second housing 520) and may be fixed when the electronic device 101 operates from the unfolded state to the folded state. The second area S2 of the heat dissipation member 610 may be disposed over the first housing 610, but may not be attached thereto, and thus, may slide with respect to at least a portion of the fixed first area S1 when the electronic device 101 operates from the unfolded state to the folded state.

According to an embodiment, when the electronic device 101 operates from the unfolded state to the folded state, at least a portion of the heat dissipation member 610 may be bent to correspond to the display 530. For example, in the unfolded state of the electronic device 101, the central area of the heat dissipation member 610 may be disposed to overlap the bending area 333 of the display 530 and may be in a flat state. When the electronic device 101 operates from the unfolded state to the folded state, and in the folded state, the central area of the heat dissipation member 610 (e.g., the stacked thermally conductive sheet and metal sheet) may be disposed to overlap the bending area 533 of the display 530 and may be in the bent state.

According to an embodiment, when the electronic device 101 operates from the unfolded state to the folded state, one end S2a of the second area S2 of the heat dissipation member 610 may slide toward the folding axis F, and the area SS of the first housing 510 facing the display 530 where the heat dissipation member 610 is excluded may increase.

According to an embodiment, in the unfolded state of the electronic device 101, when viewed through from above the display 530 (e.g., see FIG. 15) (e.g., under the display 530 (in the -Z-axis direction)), the heat dissipation member 610 may be disposed not to overlap the first hinge device 640 and the second hinge device 640-1, which are spaced apart from each other along the folding axis F. For example, the second area S2 of the heat dissipation member 610 may extend from a partial area of the first housing 510 to a partial area of the second housing 520. A portion of the second area S2 of the heat dissipation member 610 disposed near the folding axis F may be disposed to cross between the first hinge device 640 and the second hinge device 640-1.

According to an embodiment, the board unit 560 may include a first circuit board (e.g., the first circuit board 562 of FIG. 14) disposed in the first housing 510 and a second circuit board (e.g., the second circuit board 564 of FIG. 14 or a main circuit board) disposed in the second housing 520. According to an embodiment, the first circuit board 562 and the second circuit board 564 may be electrically connected by at least one flexible circuit board 566. According to an embodiment, at least a portion of the flexible circuit board 566 may be disposed across the hinge assembly 502. The board unit 560 may include a flexible heat dissipation member 670 positioned to at least partially correspond to the flexible circuit board 566. The flexible heat dissipation member 670 may be disposed along a partial area of the flexible circuit board 566 to diffuse heat generated or moved from the flexible circuit board 566. At least a portion of the flexible heat dissipation member 670 may be disposed across the hinge assembly 502. For example, the flexible heat dissipation member 670 may extend to a board unit (e.g., the second circuit board 564 in the second housing 520 and the first circuit board 562 in the first housing 510) to diffuse heat generated from the board unit to two opposite sides.

According to an embodiment, in the unfolded state of the electronic device 101, when viewed through from above the display 530 (e.g., see FIG. 17) (e.g., when viewed downward of the display 530 (in the -Z-axis direction)), at least a portion of the heat dissipation member 610 (e.g., the second area S2 of the heat dissipation member 610) may be disposed across the folding axis F and may overlap the flexible circuit board 566. According to an embodiment, in the unfolded state of the electronic device 101, when viewed through from above the display 530 (e.g., see FIG. 17), at least a portion of the heat dissipation member 610 (e.g., the second area S2 of the heat dissipation member 610) may be disposed across the folding axis F and may overlap the hinge plate 650 of the hinge assembly. According to an embodiment, in the unfolded state of the electronic device 101, when viewed through from above the display 530 (e.g., see FIG. 17), at least a portion of the heat dissipation member 610 (e.g., the second area S2 of the heat dissipation member 610) may be disposed across the folding axis F and may overlap the flexible heat dissipation member 670. According to an embodiment, in the folding axis F and an area adjacent thereto, a portion of the second area S2 of the heat dissipation member 610, a portion of the hinge plate 650, and a portion of the flexible circuit board 566 may be stacked. According to an embodiment, in the folding axis F and an area adjacent thereto, a portion of the second area S2 of the heat dissipation member 610, a portion of the hinge plate 650, and a portion of the flexible heat dissipation member 670 may be stacked.

According to an embodiment, in the unfolded state of the electronic device 101, when viewed through from above the display 530 (e.g., see FIG. 17) (e.g., when viewed downward of the display 530 (in the -Z-axis direction)), at least a portion of the heat dissipation member 610 and the waterproof member 660 may be disposed not to overlap each other. For example, a portion of the heat dissipation member 610 (e.g., the second area S2 of the heat dissipation member 610) overlapping the first housing 510 may be disposed not to overlap the second waterproof member 662. For example, a portion of the heat dissipation member 620 (e.g., the first area S1 of the heat dissipation member 620) overlapping the second housing 520 may be disposed to overlap the first waterproof member 661 in a partial area but not to overlap the first waterproof member 661 in another partial area.

According to an embodiment, a portion of the heat dissipation member 610 (e.g., the first area S1 or the second area S2 of the heat dissipation member 610) may be disposed adjacent to the waterproof member 660. For example, the first area S1 (e.g., an end portion) of the heat dissipation member 610 may be disposed adjacent to a line where the first waterproof member 661 is disposed. Some line of the first waterproof member 661 may be disposed to surround at least a portion of the first area S1. For example, the second area S2 (e.g., an end portion) of the heat dissipation member 610 may be disposed adjacent to a line where the second waterproof member 662 is disposed. Some line of the second waterproof member 662 may be disposed to surround at least a portion of second first area S2.

According to an embodiment, the electronic device 101 may include a display adhesive member 690 disposed on the second housing 520 and disposed adjacent to the heat dissipation member 610 and the waterproof member 660. The display adhesive member 690 may enhance coupling between the display 530 and the second housing 520 without overlapping the heat dissipation member 610 (e.g., the first area S1 of the heat dissipation member 610) and the waterproof member 660.

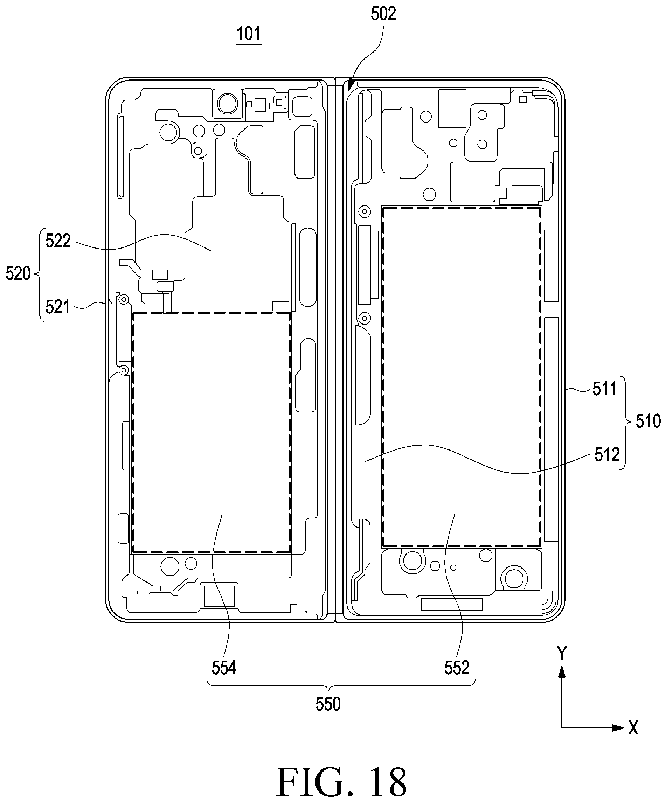

FIG. 18 is a view illustrating internal components facing rearward in an unfolded state of an electronic device according to an embodiment of the disclosure.

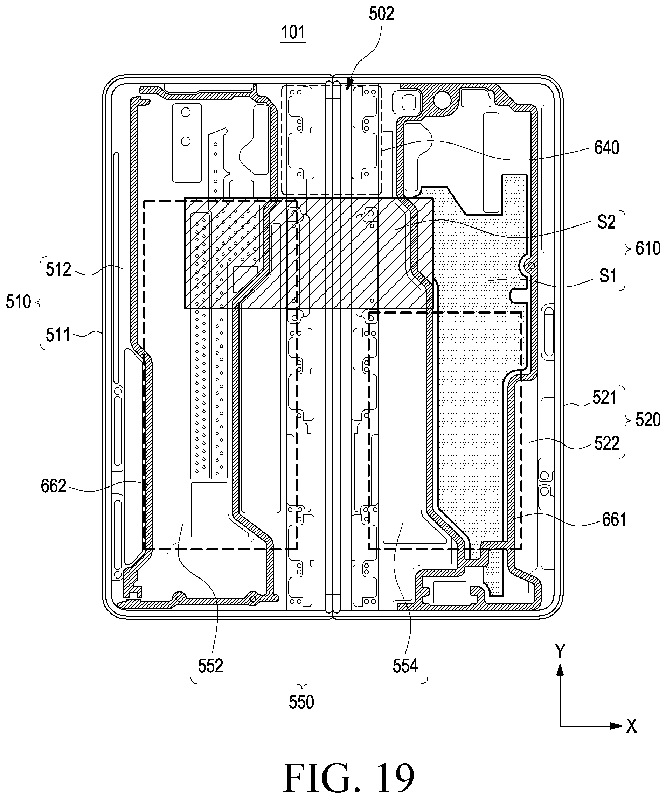

FIG. 19 is a view illustrating internal components facing forward in an unfolded state of an electronic device according to an embodiment of the disclosure.

The electronic device 101 of FIGS. 18 and 19, as an example of the electronic device 101 shown in FIG. 1, may be a foldable or bendable electronic device.

According to an embodiment, the electronic device 101 may include a first housing 510, a second housing 520, a hinge device 640, a heat dissipation member 610, a waterproof member 660, and a battery 550. The configuration of the first housing 510, the second housing 520, the hinge device 640, the heat dissipation member 610, the waterproof member 660, and the battery 550 of FIGS. 18 and 19 may be identical in whole or part to the configuration of the first housing 510, the second housing 520, the hinge device 640, the heat dissipation member 610, the waterproof member 660, and the battery 550 of FIGS. 13A to 17.

The structures of FIGS. 18 and 19 may be selectively coupled to the structures of FIGS. 2 to 17 and/or FIGS. 20 to 30.

According to an embodiment, the first housing 510 and the second housing 520 may be assembled together to be coupled to two opposite sides of the hinge assembly 502 (e.g., the hinge device 640). According to an embodiment, the battery 550 may include a first battery 552 and a second battery 554, the first battery 552 may be disposed in the first support area 512 of the first housing 510, and the second battery 554 may be disposed in the second support area 522 of the second housing 520. For example, according to an embodiment, the first battery 552 may be disposed on a surface facing in the rear direction of the first support area 512, and the second battery 554 may be disposed on a surface facing in the rear direction of the second support area 522. A length (e.g., Y-axis direction) of the first battery 552 may be larger than a length (e.g., Y-axis direction) of the second battery 554.

According to an embodiment, the heat dissipation member 610 may include a first area S1 disposed adjacent to a heat source (e.g., the heat source 630 of FIG. 17) disposed on a board unit (e.g., a main circuit board), and a second area S2 extending from the first area S1. According to an embodiment, the first area S1 of the heat dissipation member 610 may be fixed to the second housing 520 or at least one component accommodated in the second housing 520, and the second area S2 may slide when the electronic device operates from the unfolded state to the folded state (or from the folded state to the unfolded state).

According to an embodiment, the first area S1 may be disposed in the second support area 522 of the second housing 520, and the second area S2 may be disposed in the first support area 512 of the first housing 510. For example, according to an embodiment, the first area S1 may be disposed on a surface facing in the front direction of the second support area 522, and the second area S2 may be disposed on a surface facing in the front direction of the first support area 512.

According to an embodiment, a partial area of the heat dissipation member 610 may overlap the first battery 552. For example, at least a portion of the second area S2 of the heat dissipation member 610 may be disposed to overlap a portion of the first battery 552. For example, at least a portion of the second area S2 of the heat dissipation member 610 may be disposed to face a portion of the first battery 552 with the first support area 512 interposed therebetween. According to an embodiment, a partial area of the heat dissipation member 610 may not overlap the second battery 552. For example, the first area S1 of the heat dissipation member 610 may not overlap the second battery 554. For example, the first area S1 of the heat dissipation member 610 may not face the second battery 554 with the second support area 522 interposed therebetween.

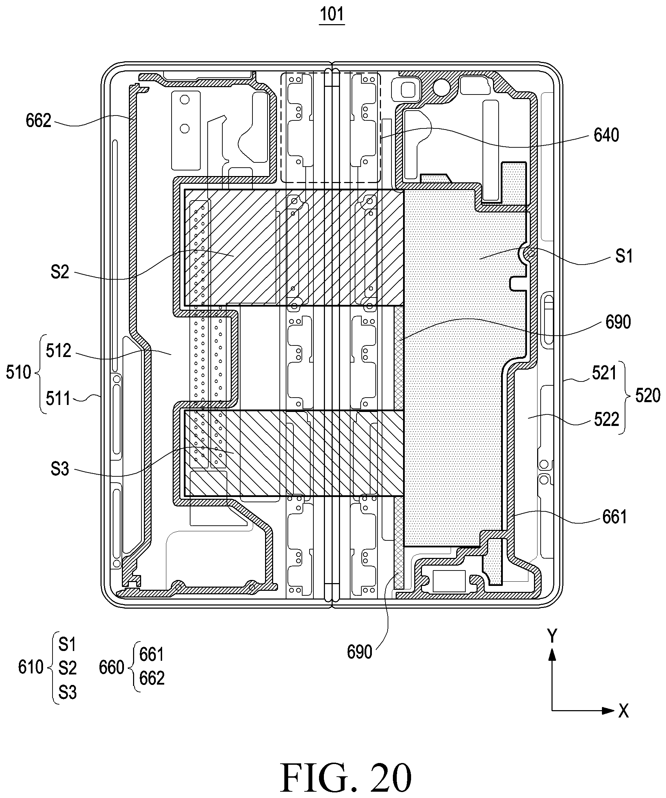

FIG. 20 is a view illustrating internal components facing forward in an unfolded state of an electronic device according to an embodiment of the disclosure.

The electronic device 101 of FIG. 20, as an example of the electronic device 101 shown in FIG. 1, may be a foldable or bendable electronic device.

According to an embodiment, the electronic device 101 may include a first housing 510, a second housing 520, a hinge device 640, a heat dissipation member 610, and a waterproof member 660. The configuration of the first housing 510, the second housing 520, the hinge device 640, the heat dissipation member 610, and the waterproof member 660 of FIG. 20 may be identical in whole or part to the configuration of the first housing 510, the second housing 520, the hinge device 640, the heat dissipation member 610, and the waterproof member 660 of FIGS. 13A to 19.

The structure of FIG. 20 may be selectively coupled to the structure of FIGS. 2 to 19 and/or FIGS. 21 to 30.

According to an embodiment, the heat dissipation member 610 may include a first area S1 disposed adjacent to a heat source (e.g., the heat source 630 of FIG. 17) disposed on a board unit (e.g., a main circuit board), and a second area S2 and a third area S3 extending from the first area S1.

According to an embodiment, a portion of the heat dissipation member 610 may be branched into a plurality of portions. For example, the second area S2 and the third area S3 of the heat dissipation member 610 may extend from one side of the first area S1 and may be spaced apart from each other in the Y-axis direction. The second area S2 and the third area S3 of the heat dissipation member 610 may be areas protruding from the first area S1 in the X-axis direction. The first area S1 of the heat dissipation member 610 may be fixed to the second housing 520 or at least one component accommodated in the second housing 520, and the second area S2 and the third area S2 of the heat dissipation member 610 may slide when the electronic device operates from the unfolded state to the folded state (or from the folded state to the unfolded state).

According to an embodiment, the first area S1 of the heat dissipation member 610 may be disposed on the second support area 522 of the second housing 520, and the second area S2 and the third area S3 of the heat dissipation member 610 may be disposed on the first support area 512 of the first housing 510.

According to an embodiment, the first waterproof member 661 may be disposed to partially overlap the first area S1 of the heat dissipation member 610.

According to an embodiment, the first waterproof member 661 and the second waterproof member 662 may be disposed not to overlap the second area S2 and the third area S3 of the heat dissipation member 610. The second waterproof member 662 may be disposed to surround at least a portion of the second area S2 and/or at least a portion of the third area S3 of the heat dissipation member 610. For example, a partial area of the second waterproof member 662 may be disposed between the second area S2 and the third area S3 of the heat dissipation member 610.

According to an embodiment, the display adhesive member 690 may be disposed on the second housing 520 along one side of the first area S1 of the heat dissipation member 610. At least a portion of the display adhesive member 690 may be disposed between the second area S2 and the third area S3 of the heat dissipation member 610, or may be disposed adjacent to the second area S2 and/or the third area S3 of the heat dissipation member 610.

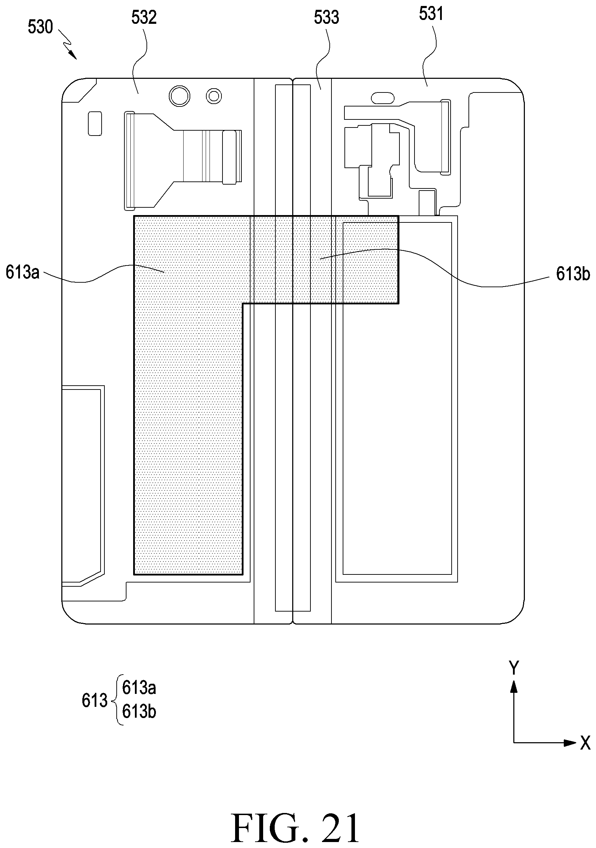

FIG. 21 is a view illustrating a rear surface of a display and a heat dissipation member disposed on the rear surface in an unfolded state of an electronic device according to an embodiment of the disclosure.

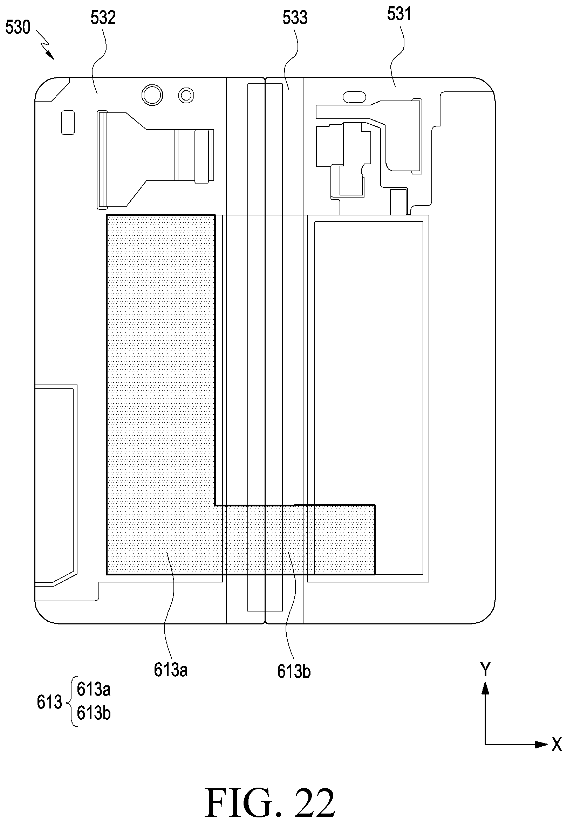

FIG. 22 is a view illustrating a rear surface of a display and a heat dissipation member disposed on the rear surface in an unfolded state of an electronic device according to an embodiment of the disclosure.

The electronic device 101 of FIGS. 21 and 22, as an example of the electronic device 101 shown in FIG. 1, may be a foldable or bendable electronic device.

According to an embodiment, the electronic device 101 may include a first housing (e.g., the first housing 510 of FIG. 15), a second housing (e.g., the second housing 520 of FIG. 15), a display 530, and a heat dissipation member 610. The configuration of the first housing 510, the second housing 520, the display 530, and the heat dissipation member 610 of FIGS. 21 and 22 may be identical in whole or part to the configuration of the first housing 510, the second housing 520, the display 530, and the heat dissipation member 610 of FIGS. 13A to 20.

The structures of FIGS. 21 and 22 may be selectively coupled to the structures of FIGS. 2 to 17 and/or FIGS. 23 to 30.

Hereinafter, the structure of FIGS. 21 and 22 is described together with the structure of FIG. 15.

According to an embodiment, the heat dissipation member 610 may include a first area S1 disposed adjacent to a heat source (e.g., the heat source 630 of FIG. 17) disposed on a board unit (e.g., a main circuit board), and a second area S2 extending from the first area S1.

According to an embodiment, a plurality of heat dissipation members 610 may be disposed. For example, the heat dissipation member 610 may include a first heat dissipation member 611 and a third heat dissipation member 613 stacked in a direction perpendicular to the X-axis and Y-axis directions. At least a portion of the first heat dissipation member 611 and the third heat dissipation member 613 may be disposed to face each other.

According to an embodiment, referring to FIGS. 15 and 21 (or FIGS. 15 and 22), the first area S1 of the first heat dissipation member 611 may be fixed to the second housing 520 or at least one component accommodated in the second housing 520, and the second area S2 of the first heat dissipation member 611 may slide when the electronic device operates from the unfolded state to the folded state (or from the folded state to the unfolded state). The first area S1 of the first heat dissipation member 611 may be disposed on the second support area 522 of the second housing 520, and the second area S2 of the first heat dissipation member 611 may be disposed on the first support area 512 (and/or a portion of the second support area 522) of the first housing 510.

According to an embodiment, referring to FIGS. 15 and 21 (or FIGS. 15 and 22), the first area 613a of the third heat dissipation member 613 may be fixed to the display 530 or at least one component facing (e.g., received in) the display 530, and the second area 613b of the third heat dissipation member 613 may slide when the electronic device operates from the unfolded state to the folded state (or from the folded state to the unfolded state). The first area 613a of the third heat dissipation member 613 may be disposed on the rear surface of the second display area 532 of the display 530, and the second area 613b of the third heat dissipation member 613 may be disposed on the rear surface (and/or a portion of the second display area 532) of the first display area 532 of the display 530.

According to an embodiment, referring to FIGS. 15 and 21, the first heat dissipation member 611 and the third heat dissipation member 613 may be disposed to overlap each other. For example, the display 530 and the third heat dissipation member 613, the first heat dissipation member 611, and the housing (or the hinge assembly 502) may be stacked in order. According to an embodiment, due to the stacked arrangement of the plurality of heat dissipation members (the first heat dissipation member 611 and the third heat dissipation member 613), heat generated from the heat source is transferred to the first areas S1 and 613a and the second areas S2 and 613b of the heat dissipation members 610 and 613, and is rapidly diffused to the entire area of the flexible display, thereby enhancing heat dissipation performance.

According to an embodiment, referring to FIGS. 15 and 21, the first area S1 of the first heat dissipation member 611 and the first area 613a of the third heat dissipation member 613 may be disposed to overlap each other, and the second area S2 of the first heat dissipation member 611 and the second area 613b of the third heat dissipation member 613 may be disposed to overlap each other. Each of the thicknesses of the first heat dissipation member 611 and the third heat dissipation member 613 of FIG. 21 may be smaller than the thickness of the first heat dissipation member 611 of FIG. 15, so that the overlapping areas of the first heat dissipation member 611 and the third heat dissipation member 613 of FIG. 21 form a thickness similar to the thickness of the first heat dissipation member 611 of FIG. 15.

According to an embodiment, referring to FIGS. 15 and 22, the first area S1 of the first heat dissipation member 611 and the first area 613a of the third heat dissipation member 613 may be disposed not to overlap each other, and the second area S2 of the first heat dissipation member 611 and the second area 613b of the third heat dissipation member 613 may be disposed to overlap each other. Each of the thicknesses of the first heat dissipation member 611 and the third heat dissipation member 613 of FIG. 22 may be smaller than the thickness of the first heat dissipation member 611 of FIG. 15, so that the overlapping areas of the first heat dissipation member 611 and the third heat dissipation member 613 of FIG. 22 form a thickness similar to the thickness of the first heat dissipation member 611 of FIG. 15.

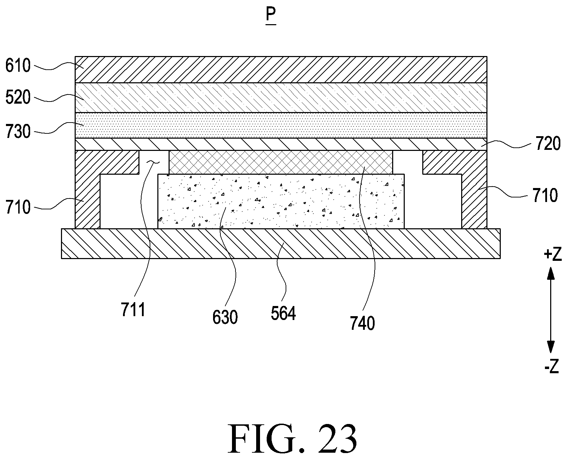

FIG. 23 is an enlarged, cross-sectional view illustrating area P of FIG. 17 according to an embodiment of the disclosure.

The electronic device 101 of FIG. 23, as an example of the electronic device 101 shown in FIG. 1, may be a foldable or bendable electronic device.

According to an embodiment, the electronic device 101 may include a second housing 520 (or the first housing 510), a heat dissipation member 610, and a heat source 630 (e.g., the heat source 330 of FIG. 5). The configuration of the second housing 520 (or the first housing 510), the heat dissipation member 610, and the heat source 630 of FIG. 23 may be identical in whole or part to the configuration of the second housing 520 (or the first housing 510), the heat dissipation member 610, and the heat source 630 of FIGS. 13A to 22.

The structure of FIG. 23 may be selectively coupled to the structure of FIGS. 2 to 22 and/or FIGS. 24 to 30.

An electronic device (e.g., the electronic device 101 of FIG. 17) may include a second circuit board 564, at least one heat source 630, a shield can 710, a shielding sheet 720, at least one heat transfer member (e.g., the first heat transfer member 730 and the second heat transfer member 740), a second housing 520, and a heat dissipation member 610.

According to an embodiment, at least one electrical element may be disposed on at least one side surface of the second circuit board 564. Among the at least one electric component, some heat source 630 may be a component that generates heat and may be at least one chip which is disposed on at least one side surface of the second circuit board 564 (e.g., main circuit board) which may include at least one of a power management integrated circuit (PMIC), a power amplifier (PAM), an application processor (AP), a communication processor (CP), and a charger integrated circuit (IC). In the present embodiment, the heat source 630 may be an application processor (AP).

According to various embodiments, the shield can 710 may be formed to surround at least a portion of the heat source 630. When viewed from above the display 530 of the electronic device (e.g., when viewed in the -Z direction), the shield can 710 may be a structure in which a first opening 711 is formed in an area in which at least a portion of the heat source 630, which may contact another material, is positioned or in a space facing the heat source 630 so that heat generated from the heat source 630 is discharged to the outside. The shield can 710 may be coupled to one surface (e.g., one surface facing in the first direction (+Z)) of the second circuit board 564. At least a portion of one surface of the second circuit board 564 and the shield can 710 may be coupled by a soldering process. For example, the shield can 710 may include an upper surface including the first opening 711 and side surfaces forming a space between the upper surface and the second circuit board 564. The first opening 711 may provide a movement path of heat generated from the heat source 630, and the shield can 710 may be manufactured in a shape (e.g., a closed rectangular loop) surrounding at least a portion of the heat source 630.

According to an embodiment, the shielding sheet 720 may be disposed on one side surface of the heat source 630, and may serve to prevent electromagnetic waves that may be generated from the heat source 630 from affecting other electrical elements (not shown) disposed inside the electronic device.

According to an embodiment, the shielding sheet 720 may be disposed on at least a portion of the shield can 710 and may provide a shielding function for electromagnetic waves that may be generated by the heat source 630 and a heat conduction function for transferring heat that may be generated by the heat source 630 to the outside of the heat source 630. According to an embodiment, the shielding layer 720 may be disposed to at least partially cover the first opening 711 of the shield can 710 to shield electromagnetic waves of the heat source 630. According to an embodiment, the shielding sheet 720 may be disposed along a portion where the first opening 711 is formed and a peripheral portion of the first opening 711 on one side surface (e.g., an upper surface) of the shield can 710.

According to an embodiment, the first heat transfer member 730 may be disposed so that at least one surface thereof contacts the shielding sheet 720. The first heat transfer member 730 may be disposed between the second housing 520 and the heat source 630 and may include various heat dissipation materials or members to effectively receive heat from the heat source 630. For example, various heat dissipation materials or members may include a heat pipe, a heat dissipation sheet, a heat dissipation paint, or the like. Here, the material of the heat pipe, the heat dissipation sheet, or the heat dissipation paint may include, e.g., a high heat conduction material such as graphite, carbon nanotubes, a natural regeneration material, silicone, silicon, graphite, or the like.

According to an embodiment, the second heat transfer member 740 may be disposed between the heat source 630 and the shielding sheet 720 to provide a heat transfer path for transferring heat generated from the heat source 630 to the shielding sheet 720. At least a portion of the second heat transfer member 740 may be disposed to pass through the first opening 711 of the shield can 710, an upper surface (e.g., one surface facing the +Z axis) thereof may be disposed to contact the first heat transfer member 730, and a lower surface (e.g., one surface facing the -Z axis) may be disposed to directly contact at least a portion of the heat source 630.

According to an embodiment, the second heat transfer member 740 may be formed of a carbon fiber thermal interface material (TIM) capable of transferring heat generated from the heat source 630. However, the second heat transfer member 740 is not limited to the carbon fiber TIM, and may include various heat dissipation materials or members for transferring heat generated from the heat source 630 to the second housing 520 (and the heat dissipation member 610 disposed on the housing). The carbon fiber TIM may include at least one of a liquid phase thermal interface material (TIM) and/or a solid phase thermal interface material (TIM).

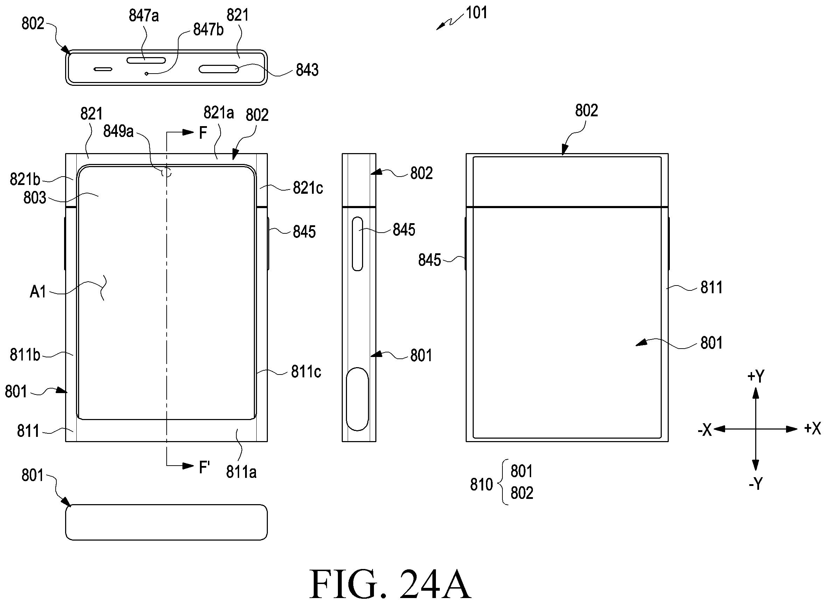

FIG. 24A is a view illustrating a state in which a second display area of a display is received in a housing according to an embodiment of the disclosure.

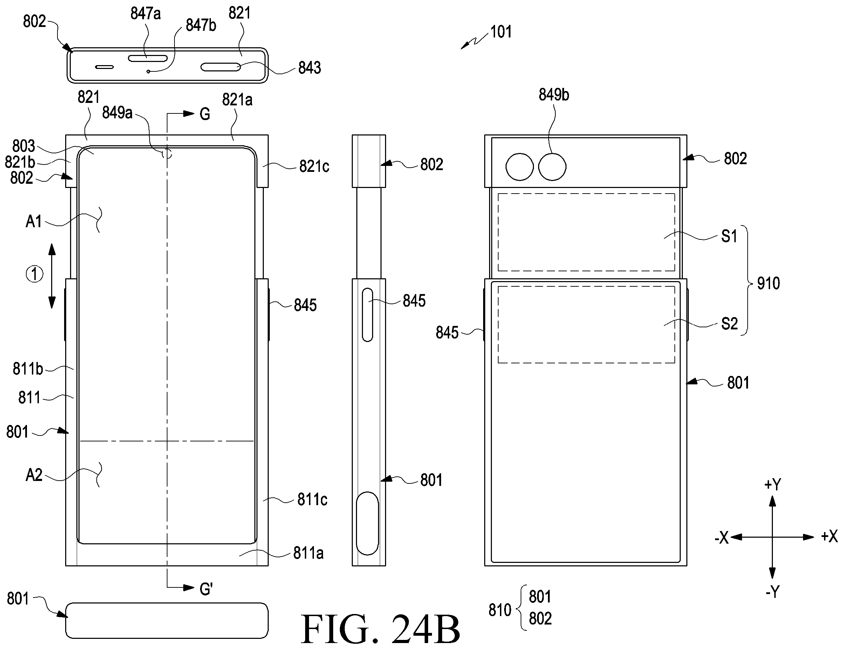

FIG. 24B is a view illustrating a state in which a second display area of a display is exposed to the outside of a housing according to an embodiment of the disclosure.

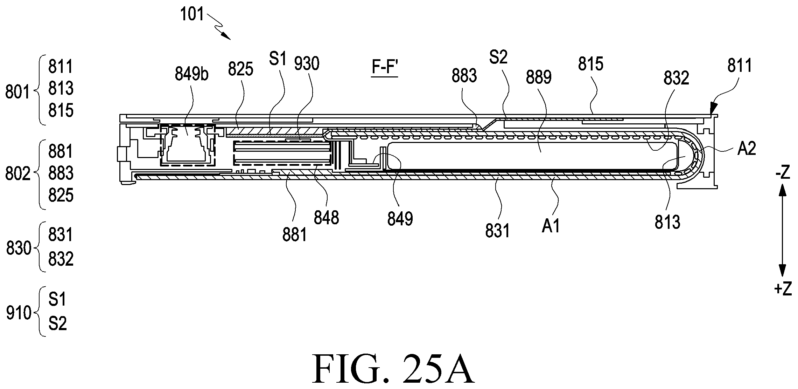

FIG. 25A is a cross-sectional view taken along line F-F' of FIG. 24A according to an embodiment of the disclosure.

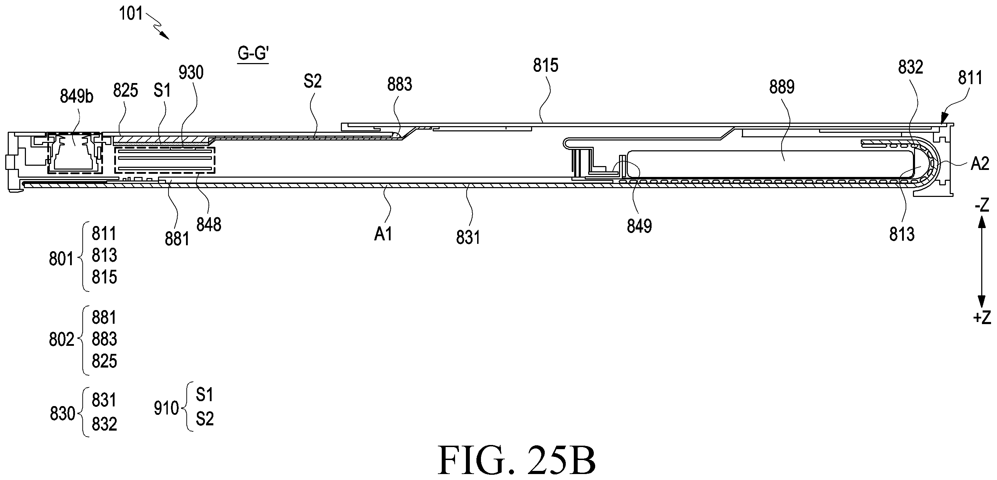

FIG. 25B is a cross-sectional view taken along line G-G' of FIG. 24B according to an embodiment of the disclosure.

FIGS. 24A and 24B illustrate a structure in which the display 803 (e.g., flexible display or rollable display) is extended in the length direction (e.g., +Y direction) when the electronic device 101 is viewed from the front. However, the extending direction of the display 803 is not limited to one direction (e.g., +Y direction). For example, the extending direction of the display 803 may be changed in design to be extendable in the upper direction (+Y direction), right direction (e.g., +X direction), left direction (e.g., -X direction), and/or lower direction (e.g., -Y direction).

The state illustrated in FIG. 24A may be referred to as a slide-in state of the electronic device 101 or a state in which the second display area A2 of the display 803 is closed.

The state illustrated in FIG. 24B may be referred to as a slide-out state of the electronic device 101 or a state in which the second display area A2 of the display 803 is open.

Referring to FIGS. 24A and 24B, the electronic device 101 may include a housing 810. The housing 810 may include a first housing 801 and a second housing 802 disposed to be movable relative to the first housing 801. According to an embodiment, the electronic device 101 may be interpreted as having a structure in which the first housing 801 is disposed to be slidable with respect to the second housing 802. According to an embodiment, the second housing 802 may be disposed to perform reciprocating motion by a predetermined distance in the shown direction with respect to the first housing 801, for example, a direction indicated by the arrow η.

According to an embodiment, the second housing 802 may be referred to as a slide portion or a slide housing, and may be movable relative to the first housing 801. According to an embodiment, the second housing 802 may accommodate various electrical and electronic components, such as a circuit board or a battery.

According to an embodiment, the first housing 801 may accommodate a sub circuit board (e.g., the second circuit board 849 of FIGS. 25A and 25B) electrically connected to a motor, a speaker, a SIM socket, and/or the main circuit board. The second housing 802 may accommodate a main circuit board (e.g., the first circuit board 848 of FIGS. 25A and 25B) on which electrical components such as an application processor (AP) and a communication processor (CP) are mounted.

According to an embodiment, the first housing 801 may include a first cover member 811. The first cover member 811 may include a 1-1th sidewall 811a, a 1-2th sidewall 811b extending from the 1-1th sidewall 811a, and a 1-3th sidewall 811c extending from the 1-1th sidewall 811a and substantially parallel to the 1-2th sidewall 811b. According to an embodiment, the 1-2th sidewall 811b and the 1-3th sidewall 811c may be formed substantially perpendicular to the 1-1th sidewall 811a. According to an embodiment, the first cover member 811 may be referred to as a main case or a cover member.

According to an embodiment, the 1-1th sidewall 811a, the 1-2th sidewall 811b, and the 1-3th sidewall 811c of the first cover member 811 may be formed in a shape in which one side (e.g., a front surface) of the first cover member 811 is open to accommodate (or surround) at least a portion of the second housing 802. For example, at least a portion of the second housing 802 may be surrounded by the first housing 801 and be slid in the direction parallel to the first surface (e.g., the surface facing the +Z axis), e.g., arrow ① direction, while being guided by the first housing 801. According to an embodiment, the 1-1th sidewall 811a, the 1-2th sidewall 811b, and/or the 1-3th sidewall 811c of the first cover member 811 may be integrally formed. According to an embodiment, the 1-1th sidewall 811a, the 1-2th sidewall 811b, and/or the 1-3th sidewall 811c of the first cover member 811 may be formed as separate structures and be combined or assembled.

According to an embodiment, the first cover member 811 may be formed to surround at least a portion of the display 803. For example, at least a portion of the display 803 may be formed to be surrounded by the 1-1th sidewall 811a, the 1-2th sidewall 811b, and/or the 1-3th sidewall 811c of the first cover member 811.

According to an embodiment, the second housing 802 may include a second cover member 821 (e.g., a slide plate). The second cover member 821 may have a plate shape and include a first surface (e.g., the surface facing the +Z axis) supporting internal components. For example, the second cover member 821 may support at least a portion of the display 803 (e.g., the first display area A1). According to an embodiment, the second cover member 821 may be referred to as a front cover.

According to an embodiment, the second cover member 821 may include a 2-1th sidewall 821a, a 2-2th sidewall 821b extending from the 2-1th sidewall 821a, and a 2-3th sidewall 821c extending from the 2-1th sidewall 821a and substantially parallel to the 2-2th sidewall 821b. According to an embodiment, the 2-2th sidewall 821b and the 2-3th sidewall 821c may be formed substantially perpendicular to the 2-1th sidewall 821a. According to an embodiment, the second cover member 821 may be referred to as a sub cover member.

According to an embodiment, as the second housing 802 moves in a first direction (e.g., direction ①) parallel to the 2-2th sidewall 811b or the 2-3th sidewall 811c, the slide-in state and slide-out state of the electronic device 101 may be formed. In the slide-in state of the electronic device 101, the second housing 802 may be positioned at a first distance from the 1-1th sidewall 811a of the first housing 801. In the slide-out state of the electronic device 101, the second housing 802 may move to be positioned at a second distance larger than the first distance from the 1-1th sidewall 811a of the first housing 801. In an embodiment, in the slide-in state of the electronic device 101, the first housing 801 may be formed to surround a portion of the 2-2th sidewall 821b and the 2-3th sidewall 821c.

According to an embodiment, the electronic device 101 may have an intermediate state between the slide-in state (e.g., fully closed state) of FIG. 24A and the slide-out state (e.g., fully open state) of FIG. 24B. The distance between the 1-1th sidewall 811a and the 2-1th sidewall 821a in the intermediate state of the electronic device 101 may be shorter than the distance between the 1-1th sidewall 811a and the 2-1th sidewall 821a of the electronic device 101 in the fully open state and be longer than the distance between the 1-1th sidewall 811a and the 2-1th sidewall 821a of the electronic device 101 in the fully closed state.

According to an embodiment, as at least a portion of the display 803 slides in the intermediate state of the electronic device 101, the area exposed to the outside may vary. For example, in the intermediate state of the electronic device 101, the ratio of the width (length in the X direction) to the height (length in the Y direction) of the display 803 and/or the distance between the 1-1th sidewall 811a and the 2-1th sidewall 821a may be changed based on the slide of the electronic device 101.

According to an embodiment, the electronic device 101 may include a display 803, a key input device 845, a connector hole 843, audio modules 847a and 847b, or camera modules 849a and 249b. According to an embodiment, the electronic device 101 may further include an indicator (e.g., a light emitting diode (LED) device) or various sensor modules.

According to an embodiment, the display 803 may include a first display area A1 and a second display area A2 configured to be exposed to the outside of the electronic device 101 based on the slide of the second housing 802. According to an embodiment, the first display area A1 may be disposed on the second housing 802. For example, the first display area A1 may be disposed on the second cover member 821 of the second housing 802. According to an embodiment, the second display area A2 may extend from the first display area A1, and the second display area A2 may be received in the first housing 801 or visually exposed to the outside of the electronic device 101 as the second housing 802 slides relative to the first housing 801. According to an embodiment, as the electronic device 101 changes from the slide-in state to slide-out state, the display 803 may extend in the lower direction (e.g., -Y direction) of the electronic device 101. For example, in the slide-out state of the electronic device 101, the second display area A2 may be visually exposed under the display 803 (e.g., in the -Y direction). According to an embodiment, as the electronic device 101 changes from the slide-in state to slide-out state, the display 803 may extend in the upper direction (e.g., +Y direction) of the electronic device 101. For example, in the slide-out state of the electronic device 101, the second display area A2 may be visually exposed above the display 803 (e.g., in the +Y direction).

According to an embodiment, the second display area A2 may be received in the space positioned inside the first housing 801 or exposed to the outside of the electronic device 101 while being substantially guided by one area (e.g., curved surface) of the first housing 801. According to an embodiment, the second display area A2 may move based on a slide of the second housing 802 in the first direction (e.g., the direction indicated by the arrow η). For example, while the second housing 802 slides, a portion of the second display area A2 may be deformed into a curved shape in a position corresponding to the curved surface of the first housing 801.

According to an embodiment, as viewed from above the second cover member 821 (e.g., front cover), if the electronic device 101 changes from the slide-in state to slide-out state (e.g., if the second housing 802 slides to extend from the first housing 801), the second display area A2 may be gradually exposed to the outside of the first housing 801 and, together with the first display area A1, form a substantially flat surface. According to an embodiment, the display 803 may be coupled with or disposed adjacent to a touch detection circuit, a pressure sensor capable of measuring the strength (pressure) of touches, and/or a digitizer for detecting a magnetic field-type stylus pen. According to an embodiment, irrespective of the slide-in state or slide-out state of the electronic device 101, the portion of the second display area A2 may be positioned on a portion (e.g., the curved surface 813a of FIG. 4) of the first housing, and a portion of the second display area A2 may remain in the curved shape in the position corresponding to the curved surface.

According to an embodiment, the key input device 845 may be positioned in an area of the housing 810 (e.g., the first housing 801 and/or second housing 802). Depending on the appearance and the state of use, the electronic device 101 may be designed to omit the illustrated key input device 845 or to include additional key input device(s). According to an embodiment, the electronic device 101 may include a key input device (not shown), e.g., a home key button or a touchpad disposed around the home key button. According to an embodiment, at least a portion of the key input device 845 may be disposed on the 1-1th sidewall 811a, the 1-2th sidewall 811b, or the 1-3th sidewall 811c of the first housing 801. According to an embodiment, at least a portion of the key input device 845 may be disposed on the 2-1th sidewall 821a, the 2-2th sidewall 821b, and/or the 2-3th sidewall 821c of the second housing 802.

According to an embodiment, the connector hole 843 may be omitted or may accommodate a connector (e.g., a universal serial bus (USB) connector) for transmitting and receiving power and/or data with an external electronic device. According to an embodiment (not shown), the electronic device 101 may include a plurality of connector holes 843, and some of the plurality of connector holes 843 may function as connector holes for transmitting/receiving audio signals with an external electronic device. **In** the illustrated embodiment, the connector hole 843 is disposed in the second housing 802, but is not limited thereto. For example, the connector hole 843 or a connector hole not shown may be disposed in the first housing 801.

According to an embodiment, the audio modules 847a and 847b may include at least one speaker hole 847a or at least one microphone hole 847b. One of the speaker holes 847a may be provided as a receiver hole for voice calls, and the other may be provided as an external speaker hole. The electronic device 101 may include a microphone for obtaining sound. The microphone may obtain external sound of the electronic device 101 through the microphone hole 847b. According to an embodiment, the electronic device 101 may include a plurality of microphones to detect the direction of sound. According to an embodiment, the electronic device 101 may include an audio module in which the speaker hole 847a and the microphone hole 847b are implemented as one hole or may include a speaker without the speaker hole 847a (e.g., a piezo speaker). According to an embodiment, the speaker hole 847a and the microphone hole 847b may be positioned in the first housing 801 and/or the second housing 802.

According to an embodiment, the camera modules 849a and 849b may include a first camera module 849a (e.g., a front camera) and a second camera module 849b (e.g., a rear camera) (e.g., the second camera module 849b). According to an embodiment, the electronic device 101 may include at least one of a wide-angle camera, a telephoto camera, or a close-up camera. According to an embodiment, the electronic device 200 may measure the distance to the subject by including an infrared projector and/or an infrared receiver. The camera modules 849a and 249b may include one or more lenses, an image sensor, and/or an image signal processor. The first camera module 849a may be disposed to face in substantially the same direction as the display 803. For example, the first camera module 849a may be disposed in an area around the first display area A1 or overlapping the display 803. When disposed in the area overlapping the display 803, the first camera module 249a may capture the subject through the display 803. According to an embodiment, the first camera module 849a may include an under display camera (UDC) that has a screen display area (e.g., the first display area A1) that may not be visually exposed but hidden. According to an embodiment, the second camera module 849b may capture the subject in a direction substantially opposite to the first display area A1. According to an embodiment, the first camera module 849a and/or the second camera module 849b may be disposed on the second housing 802. According to an embodiment, a plurality of second camera modules 849b may be formed to provide various arrays. For example, the plurality of second camera modules 849b may be arranged along a width direction (X-axis direction) that is substantially perpendicular to the sliding direction (e.g., Y-axis direction) of the electronic device 101. As another example, the plurality of second camera modules 849b may be arranged along the sliding direction (e.g., Y-axis direction) of the electronic device 101. As another example, the plurality of second camera modules 849b may be arranged along N * M rows and columns like a matrix.

According to an embodiment, the second camera module 849b is not visually exposed to the outside of the electronic device 101 in the slide-in state of the electronic device 101 and, in the slide-out state of the electronic device 101, may capture the outside of the electronic device 101. According to an embodiment, the second camera module 849b may capture the outside of the electronic device 101 in the slide-in state and slide-out state of the electronic device 101. For example, at least a portion (e.g., the first rear plate 815 and/or the second rear plate 825 of FIG. 4) of the housing 810 may be substantially transparent. The second camera module 849b may capture the outside of the electronic device 101 through the first rear plate 815 and/or the second rear plate 825.

According to an embodiment, an indicator (not shown) of the electronic device 101 may be disposed on the first housing 801 or the second housing 802, and the indicator may include a light emitting diode to provide state information about the electronic device 101 as a visual signal. The sensor module (not shown) of the electronic device 101 may produce an electrical signal or data value corresponding to the internal operation state or external environment state of the electronic device. The sensor module may include, for example, a proximity sensor, a fingerprint sensor, or a biometric sensor (e.g., an iris/face recognition sensor or a heartrate monitor (HRM) sensor). According to another embodiment, the sensor module may further include, e.g., at least one of a gesture sensor, a gyro sensor, an atmospheric pressure sensor, a magnetic sensor, an acceleration sensor, a grip sensor, a color sensor, an infrared (IR) sensor, a temperature sensor, a humidity sensor, or an illuminance sensor. According to an embodiment, the sensor module may be disposed in the first housing 801 and/or the second housing 802. For example, at least a portion of the sensor module may be positioned in the first housing 801, and another portion thereof may be positioned in the second housing 802.

Referring to FIGS. 25A and 25B, an electronic device 101 may include a first housing 801, a second housing 802, a display assembly 830, a heat source 830, and a heat dissipation member 910.

The configuration of the first housing 801, the second housing 802, and the display assembly 830 of FIGS. 25A and 25B may be identical in whole or part to the configuration of the first housing 801, the second housing 802, and the display 803 of FIGS. 24A and 24B. The configuration of the heat source 830 and the heat dissipation member 910 of FIGS. 25A and 25B may be identical in whole or part to the configuration of the heat source 330; 630 and the heat dissipation member 310; 610 of FIGS. 25A and 25B.

The structures of FIGS. 25A and 25B may be selectively combined with the structures of FIGS. 2 to 24B and/or FIGS. 26 to 30.

According to an embodiment, the first housing 801 may include a first cover member 811 (e.g., the first cover member 811 of FIGS. 24A and 24B), a frame 813, and a first rear plate 815.

According to an embodiment, the first cover member 811 may accommodate at least a portion of the frame 813 and accommodate a component (e.g., battery 889) positioned in the frame 813. According to an embodiment, the first cover member 811 may be formed to surround at least a portion of the second housing 802. According to an embodiment, the first cover member 811 may protect the components (e.g., the second circuit board 849 and the frame 813) positioned in the first housing 801 from external impact.

According to an embodiment, the frame 813 may be connected to the first cover member 811. For example, the frame 813 may be connected to the first cover member 811. The second housing 802 is movable relative to the first cover member 811 and/or the frame 813. According to an embodiment, the frame 813 may accommodate the battery 889.

According to an embodiment, the first rear plate 815 may substantially form at least a portion of the exterior of the first housing 801 or the electronic device 101. For example, the first rear plate 815 may be coupled to the outer surface of the first cover member 811. According to an embodiment, the first rear plate 815 may provide a decorative effect on the exterior of the electronic device 101. The first rear plate 815 may be formed of at least one of metal, glass, synthetic resin, or ceramic.

According to an embodiment, the second housing 802 may include a second cover member 821, a rear cover 823, and a second rear plate 825.

According to an embodiment, the second cover member 821 may be connected to the first housing 801 and may linearly reciprocate in one direction (e.g., in the direction of arrow η of FIG. 24B).

According to an embodiment, the second cover member 821 may support at least a portion of the display 831 (e.g., the display 803 of FIGS. 24A and 24B). The second cover member 821 may be formed of a metal and/or non-metallic material (e.g., polymer). According to an embodiment, the first circuit board 848 accommodating the electronic component (e.g., the processor 120 and/or the memory 130 of FIG. 1) may be connected to the second cover member 821. According to an embodiment, the second cover member 821 may protect the components (e.g., the first circuit board 848 and the rear cover 823) positioned in the second housing 802 from external impact.

According to an embodiment, the rear cover 823 may protect a component (e.g., the first circuit board 848) positioned on the second cover member 821. For example, the rear cover 823 may be connected to the second cover member 821 and may be formed to surround at least a portion of the first circuit board 848. According to an embodiment, the rear cover 823 may include an antenna pattern for communicating with an external electronic device. For example, the rear cover 823 may include a laser direct structuring (LDS) antenna.

According to an embodiment, the second rear plate 825 may substantially form at least a portion of the exterior of the second housing 802 or the electronic device 101. For example, the second rear plate 825 may be coupled to the outer surface of the second cover member 821. According to an embodiment, the second rear plate 825 may provide a decorative effect on the exterior of the electronic device 101. The second rear plate 825 may be formed of at least one of metal, glass, synthetic resin, or ceramic.

According to an embodiment, the second housing 802 may accommodate the first circuit board 848 (e.g., a main board). According to an embodiment, the processor, memory, and/or interface may be mounted on the first circuit board 848.

According to an embodiment, the electronic device 101 may include a second circuit board 849 (e.g., a sub circuit board) spaced apart from the first circuit board 848 (e.g., a main circuit board) in the first housing 801. The second circuit board 849 may be electrically connected to the first circuit board 848 through a connection flexible board.

According to an embodiment, the battery 889 may be a device for supplying power to at least one component of the electronic device 101. The battery 189 may include a primary cell which is not rechargeable, a secondary cell which is rechargeable, or a fuel cell. The battery 889 may be integrally or detachably disposed inside the electronic device 101. According to an embodiment, the battery 889 may be formed of a single embedded battery or may include a plurality of removable batteries.

According to an embodiment, the heat dissipation member 910 may include a first area S1, at least a portion of which is disposed on the second housing 802, and a second area S2 extending from the first area S1 and disposed on the first housing 801. For example, when viewed toward the display 831, the first area S1 of the heat dissipation member 910 may overlap a portion of the second housing 802, and the second area S2 may overlap a portion of the first housing 801. For example, the first area S1 of the heat dissipation member 910 may be fixed to the second housing 802 or at least one component accommodated in the second housing 802. For example, the first area S1 of the heat dissipation member 910 may be entirely attached to the second housing 802. For example, the second area S2 of the heat dissipation member 910 may be entirely attached to the first housing 801.

According to an embodiment, the heat dissipation member 910 may include a first area S1 disposed adjacent to the heat source 930 disposed on a board unit (e.g., the first circuit board 248 of FIGS. 25A and 25B) and a second area S2 extending from the first area S1. The first area S1 of the heat dissipation member 910 may overlap a portion of the first display area A1 of the display 831, and the second area S2 of the heat dissipation member 910 may overlap a portion of the second display area A2 of the display 831. As the heat generated from the heat source 930 is transferred to the first area S1 of the heat dissipation member 910 and then diffused to the second area S2, the heat may not be concentrated in a predetermined portion of the second housing 802 and/or the display 831, and the heat may be diffused throughout the electronic device 101.

According to an embodiment, a partial area of the heat dissipation member 910 may remain fixed to the first housing 801 or the second housing 802, and another partial area may be formed to be slidable. According to an embodiment, at least a portion of the first area S1 of the heat dissipation member 910 may be attached to the second housing 802 (or at least one component accommodated in the second housing 802), and may be fixed to the second housing 802 (or at least one component accommodated in the second housing 802) when the electronic device 101 operates from the slide-in state to the slide-out state. For example, if the second housing 802 slides with respect to the first housing 801, at least a portion of the first area S1 of the heat dissipation member 910 attached to the second housing 802 may slide. According to an embodiment, the second area S2 of the heat dissipation member 910 may be disposed over the first housing 610, but may not be attached thereto to slide with respect to at least a portion of the fixed first area S1 when the electronic device 101 operates from the slide-in state to the slide-out state.

Referring to FIG. 25A, in the slide-in state of the electronic device 101, at least a portion of the second housing 802 may be disposed to be accommodated in the first housing 801. As the second housing 802 is disposed to be received in the first housing 801, the overall volume of the electronic device 101 may be reduced. According to an embodiment, when the second housing 802 is received in the first housing 801, the size of the visually exposed display 831 may be minimized. For example, if the second housing 802 is completely received in the first housing 801, the first display area A1 of the display 831 may be visually exposed, and at least a portion (e.g., a portion along the -Z axis) of the second display area A2 may be disposed between the battery 889 and the first rear plate 815.

Referring to FIG. 25B, in the slide-out state of the electronic device 101, at least a portion of the second housing 802 may protrude from the first housing 801. As the second housing 802 is disposed to protrude from the first housing 801, the overall volume of the electronic device 101 may be increased. According to an embodiment, if the second housing 802 protrudes from the first housing 801, at least a portion of the second display area A2 of the display 831, together with the first display area A1, may be visually exposed to the outside of the electronic device 101.

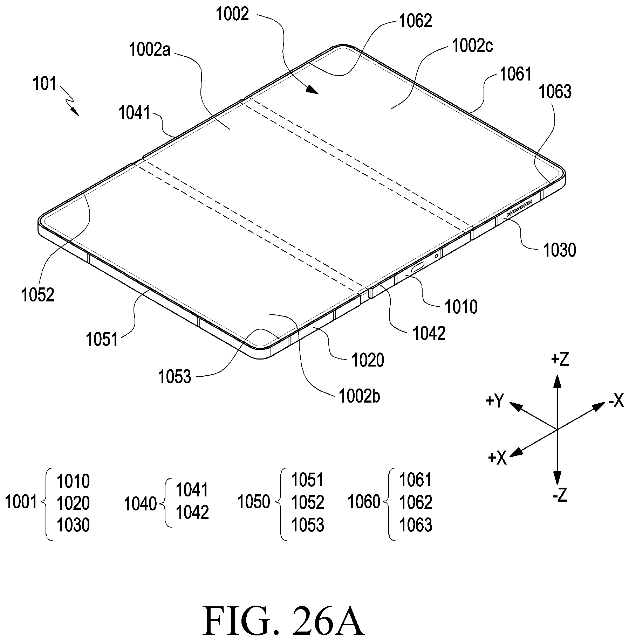

FIG. 26A is a perspective view illustrating an unfolded state of an electronic device according to an embodiment of the disclosure.

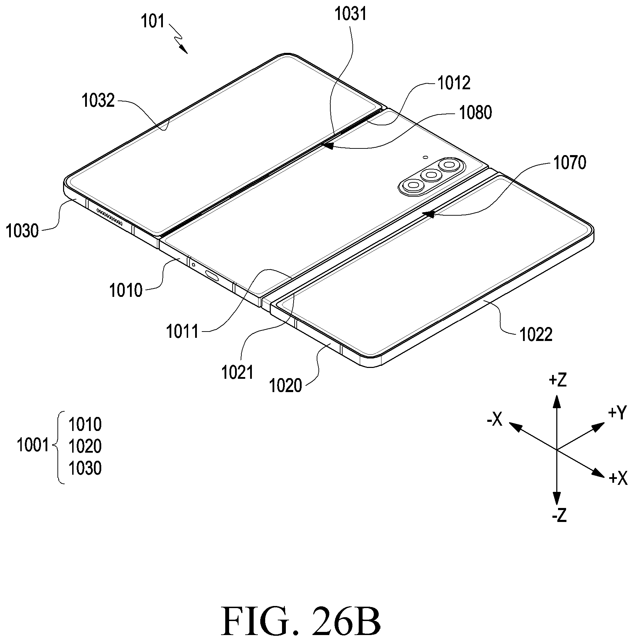

FIG. 26B is a perspective view illustrating an unfolded state of an electronic device according to an embodiment of the disclosure.

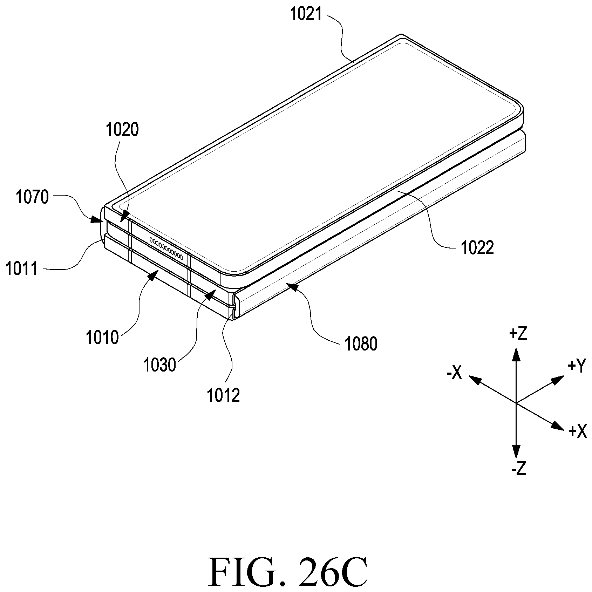

FIG. 26C is a perspective view illustrating a folded state of an electronic device according to an embodiment of the disclosure.

The components described with reference to FIGS. 26A to 26C may be identical in whole or part to the components described with reference to FIG. 1. As shown in FIGS. 26A and 26B, the unfolded state of the electronic device 101 may be defined as a "first state." As shown in FIG. 26C, the folded state of the electronic device 101 may be defined as a "second state."

According to an embodiment, the electronic device 101 may include a housing 1001. The electronic device 101 may include a display 1002. The housing 1001 may form a space where the display 1002 is disposed. The display 1002 may be a flexible display 1002. At least a portion of the display 1002 may be folded or unfolded.

According to an embodiment, the housing 1001 may include a first housing 1010. The housing 1001 may include a second housing 1020. The housing 1001 may include a third housing 1030. The first housing 1010 may be disposed between the second housing 1020 and the third housing 1030. The second housing 1020 may be rotatably coupled to the first housing 1010. The third housing 1030 may be rotatably coupled to the first housing 1010. The display 1002 may include a first display area 1002a corresponding to the first housing 1010, a second display area 1002b corresponding to the second housing 1020, and a third display area 1002c corresponding to the third housing 1030.

According to an embodiment, the electronic device 101 may include supports 1040, 1050, and 1060. The supports 1040, 1050, and 1060 may be disposed between the housing 1001 and the display 1002. The supports 1040, 1050, and 1060 may be coupled to the housing 1001 and may support the display 1002. The supports 1040, 1050, and 1060 may be disposed to surround edges of the display 1002. The supports 1040, 1050, and 1060 may extend along the circumference of the housing 1001. The supports 1040, 1050, and 1060 may include a first support 1040 disposed in the first housing 1010, a second support 1050 disposed in the second housing 1020, and a third support 1060 disposed in the third housing 1030. The support 1040, 1050, or 1060 may be referred to as a "body". The support 1040, 1050, or 1060 may be referred to as at least one of a frame, a sealing member, a peripheral part, a circumferential part, a peripheral structure, or a circumferential structure.

According to an embodiment, the supports 1040, 1050, and 1060 may include a first support 1040. The first support 1040 may be disposed between the first housing 1010 and the display 1002. The first support 1040 may be disposed along an edge of the first housing 1010. The first support 1040 may include a 1-1th support 1041 and a 1-2th support 1042. At least a portion of the display 1002 may be disposed between the 1-1th support 1041 and the 1-2th support 1042. The 1-1th support 1041 may be disposed at one end portion of the first housing 1010, and the 1-2th support 1042 may be disposed at the other end portion of the first housing 1010. Each of the first, second, and third supports 1040, 1050, and 1060 may be referred to as a "support". The support 1040, 1050, or 1060 may be referred to as a "deco," "finishing member," or "non-conductive member."

According to an embodiment, the supports 1040, 1050, and 1060 may include a second support 1050. The second support 1050 may be disposed between the second housing 1020 and the display 1002. The second support 1050 may be disposed along an edge of the second housing 1020. The second support 1050 may include a 2-1th support 1051, a 2-2th support 1052, and a 2-3th support 1053. At least a portion of the display 1002 may be disposed between the 2-2th support 1052 and the 2-3th support 1053. The 2-1th support 1051 may connect the 2-2th support 1052 and the 2-3th support 1053. The 2-1th support 1051 may extend along an edge (e.g., the edge 1022 of FIG. 26B) of the second housing 1020. The 2-1th support 1051 may be disposed between the edge 1022 of the second housing 1020 and the display 1002. The 2-1th support 1051 may be referred to as a "support frame" or a "first support frame". Each of the 2-2th support 1052 and the 2-3th support 1053 may be referred to as a "second support frame".

According to an embodiment, the supports 1040, 1050, and 1060 may include a third support 1060. The third support 1060 may be disposed between the third housing 1030 and the display 1002. The third support 1060 may be disposed along an edge of the third housing 1030. The third support 1060 may include a 3-1th support 1061, a 3-2th support 1062, and a 3-3th support 1063. At least a portion of the display 1002 may be disposed between the 3-2th support 1062 and the 3-3th support 1063. The 3-1th support 1061 may connect the 3-2th support 1062 and the 3-3th support 1063. The 3-1th support 1061 may extend along an edge (e.g., the edge 1032 of FIG. 26B) of the third housing 1030. The 3-1th support 1061 may be disposed between the edge 1032 of the third housing 1030 and the display 1002. The 3-1th support 1061 may be referred to as a "support frame" or a "first support frame". Each of the 3-2th support 1062 and the 3-3th support 1063 may be referred to as a "second support frame".

According to an embodiment, the first housing 1010 may include a 1-1th side portion 1011 and a 1-2th side portion 1012. The 1-1th side portion 1011 and the 1-2th side portion 1012 may form two opposite side surfaces, respectively, of the first housing 1010. The second housing 1020 may be coupled to the 1-1th side portion 1011. The third housing 1030 may be coupled to the 1-2th side portion 1012. The 1-1th side portion 1011 may be referred to as a "first coupling portion". The 1-2th side portion 1012 may be referred to as a "second coupling portion". The 1-1th side portion 1011 may be referred to as a "first portion". The 1-2th side portion 1012 may be referred to as a "second portion".

According to an embodiment, the second housing 1020 may include a 2-1th side portion 1021 and a 2-2th side portion 1022. The 2-1th side portion 1021 and the 2-2th side portion 1022 may form two opposite side surfaces, respectively, of the second housing 1020. The 2-1th side portion 1021 may be coupled to the first housing 1010. The 2-2th side portion 1022 may form a side surface of the housing 1001. The 2-2th side portion 1022 may be referred to as an "edge". The 2-1th side portion 1021 may be referred to as a "third side portion". The 2-2th side portion 1022 may be referred to as a "fourth side portion".

According to an embodiment, the third housing 1030 may include a 3-1th side portion 1031 and a 3-2th side portion 1032. The 3-1th side portion 1031 and the 3-2th side portion 1032 may form two opposite side surfaces, respectively, of the third housing 1030. The 3-1th side portion 1031 may be coupled to the first housing 1010. The 3-2th side portion 1032 may form a side surface of the housing 1001. The 3-2th side portion 1032 may be referred to as an "edge". The 3-1th side portion 1031 may be referred to as a "fifth side portion". The 3-2th side portion 1032 may be referred to as a "sixth side portion".

According to an embodiment, the electronic device 101 may include a first hinge 1070 and a second hinge 1080. The first hinge 1070 may be disposed between the first housing 1010 and the second housing 1020. The first hinge 1070 may be disposed between the 1-1th side portion 1011 and the 2-1th side portion 1021. The first hinge 1070 may rotatably connect the first housing 1010 and the second housing 1020. The second hinge 1080 may be disposed between the first housing 1010 and the third housing 1030. The second hinge 1080 may be disposed between the 1-2th side portion 1012 and the 3-1th side portion 1031. The second hinge 1080 may rotatably connect the first housing 1010 and the third housing 1030.

According to an embodiment, the second housing 1020 may be rotated with respect to the first housing 1010. The first hinge 1070 may provide a center of rotation to the second housing 1020. The first hinge 1070 may connect the 1-1th side portion 1011 and the 2-1th side portion 1021. The third housing 1030 may be rotated with respect to the first housing 1010. The second hinge 1080 may provide a center of rotation to the third housing 1030. The second hinge 1080 may connect the 1-2th side portion 1012 and the 3-1th side portion 1031.

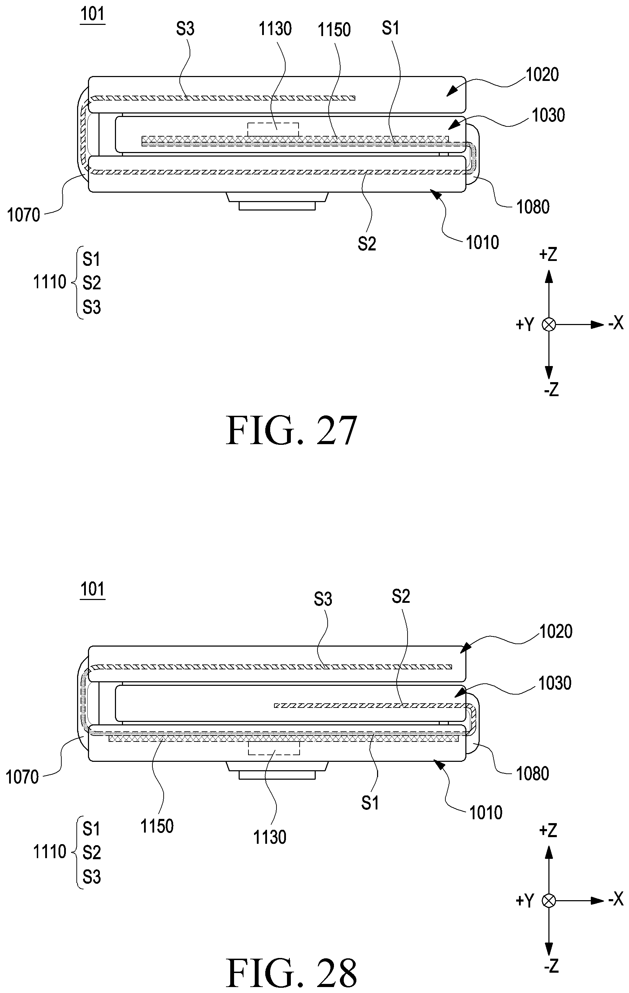

According to an embodiment, in the folded state of the electronic device 101, each of the first, second, and third housings 1010, 220, and 230 may be arranged in one direction (e.g., the +Y direction). For example, the third housing 1030 may be disposed above the first housing 1010, and the second housing 1020 may be disposed above the third housing 1030. For example, the third housing 1030 may be disposed between the first housing 1010 and the second housing 1020. (e.g., G-type multi-folding, see FIGS. 27 and 28)

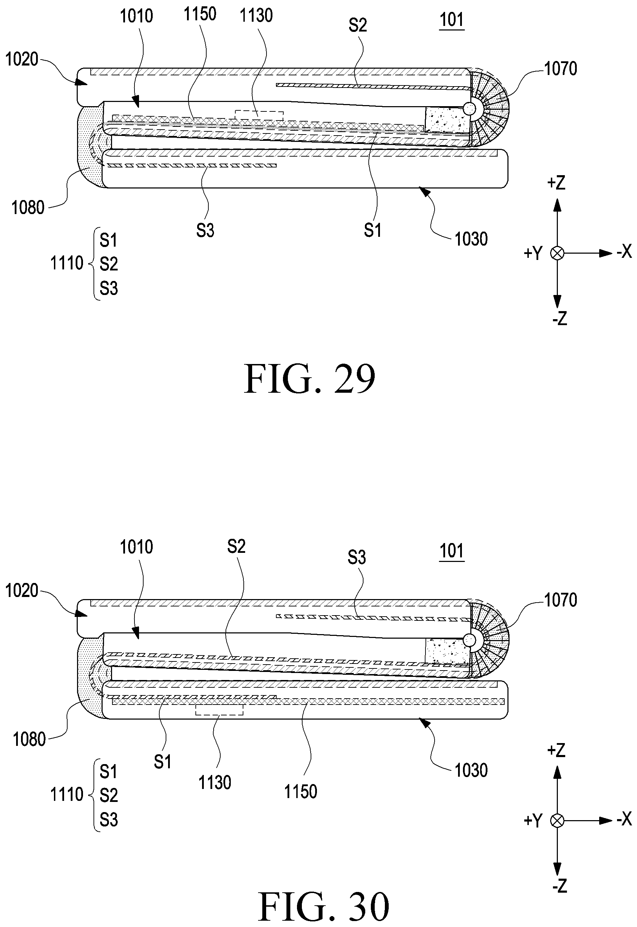

According to an embodiment, in the folded state of the electronic device 101, each of the first, second, and third housings 1010, 220, and 230 may be arranged in one direction (e.g., the +Y direction). For example, the second housing 1020 may be disposed above the first housing 1010, and the third housing 1030 may be disposed under the first housing 1010. For example, the first housing 1010 may be disposed between the second housing 1020 and the third housing **1020** (e.g., Z-type multi-folding, see FIGS. 29 and 30).

FIG. 27 is a see-through view illustrating internal components (e.g., a heat dissipation member and a heat source) in a folded state of an electronic device according to an embodiment of the disclosure.

FIG. 28 is a see-through view illustrating internal components (e.g., a heat dissipation member and a heat source) in a folded state of an electronic device according to an embodiment of the disclosure.

The electronic device 101 of FIGS. 27 and 28, as an example of the electronic device 101 shown in FIG. 1, may be a foldable or bendable electronic device.

According to an embodiment, the electronic device 101 may include a first housing 1010, a second housing 1020, a third housing 1030, a first hinge 1070, and a second hinge 1080, a heat source 1130, and a heat dissipation member 1110. The configuration of the first housing 1010, the second housing 1020, the third housing 1030, the first hinge 1070, and the second hinge 1080 of FIGS. 27 and 28 may be identical in whole or part to the configuration of the first housing 1010, the second housing 1020, the third housing 1030, the first hinge 1070, and the second hinge 1080 of FIGS. 26A to 26C. The configuration of the heat dissipation member 1110 of FIGS. 27 and 28 may be identical in whole or part to the configuration of the heat dissipation member 310 (610) 910 of FIGS. 5 to 12B, 15 to 23, and 25A to 25B.

The structure of FIGS. 27 and 28 may be selectively coupled to the structure of FIGS. 2 to 27C and/or FIGS. 29 and 30.

Referring to FIG. 27, the heat dissipation member 1110 may include a first area S1 at least partially disposed on (or inside) the third housing 1030, a second area S2 extending from the first area S1 and disposed on (or inside) the first housing 1010, and a third area S3 extending from the second area S2 and disposed on (or inside) the second housing 1020. For example, when viewed toward the display 1002 (e.g., in the unfolded state of the electronic device 101), the first area S1 of the heat dissipation member 1110 may overlap a portion of the third housing 1030, the second area S2 may overlap a portion of the first housing 1010, and the third area S3 may overlap a portion of the second housing 1020. For example, the first area S1 of the heat dissipation member 1110 may be fixed to the third housing 1030 or at least one component accommodated in the third housing 1030.

According to an embodiment, the heat dissipation member 1110 may include a first area S1 disposed adjacent to the heat source 1030 disposed on a board unit (e.g., a main circuit board), a second area S2 extending from the first area S1, and a third area S3 extending from the second area S2. In the unfolded state of the electronic device 101, the first area S1 of the heat dissipation member 1110 may overlap the third display area 1002c of the display 1002, the second area S2 of the heat dissipation member 1110 may overlap the first display area 1002a of the display 1002 and/or the second hinge 1080, and the third area S3 of the heat dissipation member 1110 may overlap the second display area 1002b of the display 1002 and/or the first hinge 1070. As the heat generated from the heat source 1030 is transferred to the first area S1 of the heat dissipation member 1110 and then diffused to the second area S2 and the third area S3, the heat may not be concentrated in a certain portion (e.g., the third display area 1002c) of the display 1002, but the heat may be diffused throughout the display 1002.

According to an embodiment, a partial area of the heat dissipation member 1110 may remain fixed to the third housing 1030, and another partial area may be formed to be slidable. For example, at least a portion of the first area S1 of the heat dissipation member 1110 may be attached to the third housing 1030 (or at least one component accommodated in the third housing 1030), and may be fixed when the electronic device 101 operates from the unfolded state to the folded state. The second area S2 of the heat dissipation member 1110 may be disposed over the first housing 1010, but may not be attached thereto, and thus, may slide with respect to at least a portion of the fixed first area S1 when the electronic device 101 operates from the unfolded state to the folded state. The third area S3 of the heat dissipation member 1110 may be disposed over the second housing 1020, but may not be attached thereto, and thus, may slide with respect to at least a portion of the fixed first area S1 when the electronic device 101 operates from the unfolded state to the folded state. When the second area S2 and the third area S3 slide, the movement amount of the third area S3 may be larger than the movement amount (e.g., the moving distance) of the second area S2.

According to an embodiment, as the heat source 1030 is disposed to contact the first area S1 of the heat dissipation member 1110, the heat dissipation member 1110 may directly receive and diffuse heat generated from the heat source 1030. According to an embodiment, as the heat source 1030 is connected to the first area S1 of the heat dissipation member 1110 through the third housing 1030, heat generated from the heat source 1030 may be diffused through the third housing 1030 and the heat dissipation member 1110. According to an embodiment, as the heat source 1030 is connected to the first area S1 of the heat dissipation member 1110 through the heat transfer member 1150 (e.g., a thermal interface material (TIM) and/or a metal bracket) disposed through the third housing 1030, heat generated from the heat source 1030 may be diffused throughout the electronic device 101 through the heat transfer member 1150.

Referring to FIG. 28, the heat dissipation member 1110 may include a first area S1 at least partially disposed on (or inside) the first housing 1010, a second area S2 extending from one end of the first area S1 and disposed on (or inside) the third housing 1030, and a third area S3 extending from the other end of the first area S1 and disposed on (or inside) the second housing 1020. For example, when viewed toward the display 1002 (e.g., in the unfolded state of the electronic device 101), the first area S1 of the heat dissipation member 1110 may overlap a portion of the first housing 1010, the second area S2 may overlap a portion of the third housing 1030, and the third area S3 may overlap a portion of the second housing 1020. For example, the first area S1 of the heat dissipation member 1110 may be fixed to the first housing 1010 or at least one component accommodated in the first housing 1010.

According to an embodiment, the heat dissipation member 1110 may include a first area S1 disposed adjacent to the heat source 1030 disposed on a board unit (e.g., a main circuit board), a second area S2 extending from one end of the first area S1, and a third area S3 extending from the other end of the first area S1. Referring to FIG. 28, the heat source 1030 is disposed in the first housing 1010, but is not limited thereto, and the heat source 1030 may be disposed in the second housing 1020.

In the unfolded state of the electronic device 101, the first area S1 of the heat dissipation member 1110 may overlap the first display area 1002a of the display 1002, the second area S2 of the heat dissipation member 1110 may overlap the third display area 1002c of the display 1002 and/or the second hinge 1080, and the third area S3 of the heat dissipation member 1110 may overlap the second display area 1002b of the display 1002 and/or the first hinge 1070. As the heat generated from the heat source 1030 is transferred to the first area S1 of the heat dissipation member 1110 and then diffused to each of the second area S2 and the third area S3, the heat may not be concentrated in a certain portion (e.g., the first display area 1002a) of the display 1002 but may be diffused throughout the display 1002.

According to an embodiment, a partial area of the heat dissipation member 1110 may remain fixed to the first housing 1010, and another partial area may be formed to be slidable. For example, at least a portion of the first area S1 of the heat dissipation member 1110 may be attached to the first housing 1010 (or at least one component accommodated in the first housing 1010), and may be fixed when the electronic device 101 operates from the unfolded state to the folded state. The second area S2 of the heat dissipation member 1110 may be disposed over the third housing 1030, but may not be attached thereto, and thus, may slide with respect to at least a portion of the fixed first area S1 when the electronic device 101 operates from the unfolded state to the folded state. The third area S3 of the heat dissipation member 1110 may be disposed over the second housing 1020, but may not be attached thereto, and thus, may slide with respect to at least a portion of the fixed first area S1 when the electronic device 101 operates from the unfolded state to the folded state. When the second area S2 and the third area S3 slide, the movement amount of the third area S3 may be larger than the movement amount (e.g., the moving distance) of the second area S2.

According to an embodiment, as the heat source 1030 is disposed to contact the first area S1 of the heat dissipation member 1110, the heat dissipation member 1110 may directly receive and diffuse heat generated from the heat source 1030. According to an embodiment, as the heat source 1030 is connected to the first area S1 of the heat dissipation member 1110 through the first housing 1010, heat generated from the heat source 1030 may be diffused through the first housing 1010 and the heat dissipation member 1110. According to an embodiment, as the heat source 1030 is connected to the first area S1 of the heat dissipation member 1110 through the heat transfer member 1150 (e.g., a thermal interface material (TIM) and/or a metal bracket) disposed through the first housing 1010, heat generated from the heat source 1030 may be diffused throughout the electronic device 101 through the heat transfer member 1150.

FIG. 29 is a see-through view illustrating internal components (e.g., a heat dissipation member and a heat source) in a folded state of an electronic device according to an embodiment of the disclosure.

FIG. 30 is a see-through view illustrating internal components (e.g., a heat dissipation member and a heat source) in a folded state of an electronic device according to an embodiment of the disclosure.

The electronic device 101 of FIGS. 29 and 30, as an example of the electronic device 101 shown in FIG. 1, may be a foldable or bendable electronic device.

The configuration of the first housing 1010, the second housing 1020, the third housing 1030, the first hinge 1070, and the second hinge 1080 of FIGS. 29 and 30 may be identical in whole or part to the configuration of the first housing 1010, the second housing 1020, the third housing 1030, the first hinge 1070, and the second hinge 1080 of FIGS. 26A to 28. The configuration of the heat dissipation member 1110 of FIGS. 29 and 30 may be identical in whole or part to the configuration of the heat dissipation member 310; 610; 910; 1110 of FIGS. 5 to 12B, 15 to 23, 25A to 25B, and 27 to 28.

The structure of FIGS. 29 and 30 may be selectively combinable with the structures of FIGS. 2 to 28.

According to an embodiment, in the folded state of the electronic device 101, each of the first, second, and third housings 1010, 220, and 230 may be arranged in one direction (e.g., the +Y direction). For example, the second housing 1020 may be disposed above the first housing 1010, and the third housing 1030 may be disposed under the first housing 1010. For example, the first housing 1010 may be disposed between the second housing 1020 and the third housing 1020 (e.g., Z-type multi-folding).

Referring to FIG. 29, the heat dissipation member 1110 may include a first area S1 at least partially disposed on (or inside) the first housing 1010, a second area S2 extending from one end of the first area S1 and disposed on (or inside) the second housing 1020, and a third area S3 extending from the other end of the first area S1 and disposed on (or inside) the third housing 1030. For example, when viewed toward the display 1002 (e.g., in the unfolded state of the electronic device 101), the first area S1 of the heat dissipation member 1110 may overlap a portion of the first housing 1010, the second area S2 may overlap a portion of the second housing 1010, and the third area S3 may overlap a portion of the third housing 1030. For example, the first area S1 of the heat dissipation member 1110 may be fixed to the first housing 1010 or at least one component accommodated in the first housing 1010.

According to an embodiment, the heat dissipation member 1110 may include a first area S1 disposed adjacent to the heat source 1030 disposed on a board unit (e.g., a main circuit board), a second area S2 extending from one end of the first area S1, and a third area S3 extending from the other end of the first area S1. In the unfolded state of the electronic device 101, the first area S1 of the heat dissipation member 1110 may overlap the first display area 1002a of the display 1002, the second area S2 of the heat dissipation member 1110 may overlap the second display area 1002b of the display 1002 and/or the first hinge 1070, and the third area S3 of the heat dissipation member 1110 may overlap the third display area 1002c of the display 1002 and/or the second hinge 1080. As the heat generated from the heat source 1030 is transferred to the first area S1 of the heat dissipation member 1110 and then diffused to each of the second area S2 and the third area S3, the heat may not be concentrated in a certain portion (e.g., the first display area 1002a) of the display 1002 but may be diffused throughout the display 1002.

According to an embodiment, a partial area of the heat dissipation member 1110 may remain fixed to the first housing 1010, and another partial area may be formed to be slidable. For example, at least a portion of the first area S1 of the heat dissipation member 1110 may be attached to the first housing 1010 (or at least one component accommodated in the first housing 1010), and may be fixed when the electronic device 101 operates from the unfolded state to the folded state. The second area S2 of the heat dissipation member 1110 may be disposed over the second housing 1020, but may not be attached thereto, and thus, may slide with respect to at least a portion of the fixed first area S1 when the electronic device 101 operates from the unfolded state to the folded state. The third area S3 of the heat dissipation member 1110 may be disposed over the third housing 1030, but may not be attached thereto, and thus, may slide with respect to at least a portion of the fixed first area S1 when the electronic device 101 operates from the unfolded state to the folded state. When the second area S2 and the third area S3 slide, the movement amount of the third area S3 may be similar to or substantially the same as the movement amount (e.g., the moving distance) of the second area S2.

According to an embodiment, as the heat source 1030 is disposed to contact the first area S1 of the heat dissipation member 1110, the heat dissipation member 1110 may directly receive and diffuse heat generated from the heat source 1030. According to an embodiment, as the heat source 1030 is connected to the first area S1 of the heat dissipation member 1110 through the first housing 1010, heat generated from the heat source 1030 may be diffused through the first housing 1010 and the heat dissipation member 1110. According to an embodiment, as the heat source 1030 is connected to the first area S1 of the heat dissipation member 1110 through the heat transfer member 1150 (e.g., a thermal interface material (TIM) and/or a metal bracket) disposed through the first housing 1010, heat generated from the heat source 1030 may be diffused throughout the electronic device 101 through the heat transfer member 1150.

Referring to FIG. 30, the heat dissipation member 1110 may include a first area S1 at least partially disposed on (or inside) the third housing 1030, a second area S2 extending from the first area S1 and disposed on (or inside) the second housing 1020, and a third area S3 extending from the second area S2 and disposed on (or inside) the first housing 1010. For example, when viewed toward the display 1002 (e.g., in the unfolded state of the electronic device 101), the first area S1 of the heat dissipation member 1110 may overlap a portion of the third housing 1030, the second area S2 may overlap a portion of the second housing 1010, and the third area S3 may overlap a portion of the first housing 1010. For example, the first area S1 of the heat dissipation member 1110 may be fixed to the third housing 1030 or at least one component accommodated in the third housing 1030.

According to an embodiment, the heat dissipation member 1110 may include a first area S1 disposed adjacent to the heat source 1030 disposed on a board unit (e.g., a main circuit board), a second area S2 extending from the first area S1, and a third area S3 extending from the second area S2. In the unfolded state of the electronic device 101, the first area S1 of the heat dissipation member 1110 may overlap the third display area 1002c of the display 1002, the second area S2 of the heat dissipation member 1110 may overlap the second display area 1002b of the display 1002 and/or the second hinge 1080, and the third area S3 of the heat dissipation member 1110 may overlap the first display area 1002a of the display 1002 and/or the first hinge 1070. As the heat generated from the heat source 1030 is transferred to the first area S1 of the heat dissipation member 1110 and then diffused to the second area S2 and the third area S3, the heat may not be concentrated in a certain portion (e.g., the third display area 1002c) of the display 1002, but the heat may be diffused throughout the display 1002.

According to an embodiment, a partial area of the heat dissipation member 1110 may remain fixed to the third housing 1030, and another partial area may be formed to be slidable. For example, at least a portion of the first area S1 of the heat dissipation member 1110 may be attached to the third housing 1030 (or at least one component accommodated in the third housing 1030), and may be fixed when the electronic device 101 operates from the unfolded state to the folded state. The second area S2 of the heat dissipation member 1110 may be disposed over the second housing 1020, but may not be attached thereto, and thus, may slide with respect to at least a portion of the fixed first area S1 when the electronic device 101 operates from the unfolded state to the folded state. The third area S3 of the heat dissipation member 1110 may be disposed over the first housing 1010, but may not be attached thereto, and thus, may slide with respect to at least a portion of the fixed first area S1 when the electronic device 101 operates from the unfolded state to the folded state. When the second area S2 and the third area S3 slide, the movement amount of the third area S3 may be larger than the movement amount (e.g., the moving distance) of the second area S2.

According to an embodiment, as the heat source 1030 is disposed to contact the first area S1 of the heat dissipation member 1110, the heat dissipation member 1110 may directly receive and diffuse heat generated from the heat source 1030. According to an embodiment, as the heat source 1030 is connected to the first area S1 of the heat dissipation member 1110 through the third housing 1030, heat generated from the heat source 1030 may be diffused through the third housing 1030 and the heat dissipation member 1110. According to an embodiment, as the heat source 1030 is connected to the first area S1 of the heat dissipation member 1110 through the heat transfer member 1150 (e.g., a thermal interface material (TIM) and/or a metal bracket) disposed through the third housing 1030, heat generated from the heat source 1030 may be diffused throughout the electronic device 101 through the heat transfer member 1150.

An electronic device 101 according to an embodiment of the disclosure may comprise a first housing 210, a second housing 220, a hinge structure 280 connecting the first housing and the second housing to be rotatable from an unfolded state to a folded state, a flexible display 230 configured to be unfolded or bent based on a relative movement of the second housing with respect to the first housing, a printed circuit board 260 disposed in the first housing, and a heat dissipation member 310 including a first area S1 extending from the first area and overlapping a portion of the first housing and a second area S2 overlapping a portion of the second housing. When the electronic device is changed from the unfolded state to the folded state, the heat dissipation member fixed to the first housing may be formed so that the second area slides with respect to the first area.

An electronic device 101 according to an embodiment of the disclosure may comprise a first housing 210, a second housing 220, a hinge structure 280 connected to the first housing and the second housing so that the first housing and the second housing are rotatable while the electronic device is changed between an unfolded state and a folded state, a flexible display 230 accommodated in the first housing and the second housing and positioned to be unfolded or bent while the electronic device is changed between the unfolded state and the folded state, and a heat dissipation member 310 including a first area S1 positioned to overlap at least a portion of the first housing when viewed in a direction perpendicular to the first housing, and a second area S2 extending from the first area and positioned to overlap at least a portion of the second housing when viewed in a direction perpendicular to the second housing. While the electronic device is in transition between the unfolded state and the folded state, the first area of the heat dissipation member may be fixed to the first housing or at least one component accommodated in the first housing, and the second area of the heat dissipation member may be configured to slide with respect to the second housing.

According to an embodiment, while the electronic device is changed from the unfolded state to the folded state, at least a portion of the heat dissipation member may be positioned to be bent to correspond to the flexible display.

According to an embodiment, while the electronic device is changed from the unfolded state to the folded state, one end of the second area of the heat dissipation member may slide toward the hinge structure.

According to an embodiment, while the electronic device is changed from the unfolded state to the folded state, when viewed in a direction perpendicular to the second housing, an area in which the flexible display and the second housing (e.g., directly facing each other) may increase.

According to an embodiment, the heat dissipation member may include a thermally conductive sheet 311 and a bendable metal sheet 312 attached to the thermally conductive sheet.

According to an embodiment, the electronic device may further comprise an adhesive sheet for fixing the thermally conductive sheet or the metal sheet to the first housing.

According to an embodiment, the thermally conductive sheet may be formed to extend from the first housing to the second housing via the hinge structure.

According to an embodiment, the metal sheet may have an area corresponding to (e.g., substantially the same as) the thermally conductive sheet.

According to an embodiment, the flexible display may include a first display area 231, a second display area 232, and a folding area 233 connecting the first display area and the second display area. When the electronic device is viewed in a direction perpendicular to the flexible display in the unfolded state, the thermally conductive sheet or the metal sheet may be disposed to overlap the folding area of the flexible display.

According to an embodiment, the first area of the heat dissipation member may be positioned to be disposed adjacent to a heat source positioned in the first housing (e.g., disposed on the printed circuit board).

According to an embodiment, the heat dissipation member may be positioned so that heat generated from the heat source is transferred to the first area and the second area of the heat dissipation member.

According to an embodiment, the electronic device may further comprise a first waterproof member 361 sealing between an edge of the first housing and one end of the flexible display and a second waterproof member 362 sealing between an edge of the second housing and another end of the flexible display. The heat dissipation member may be positioned between the first waterproof member and the second waterproof member.

According to an embodiment, the electronic device may further comprise a first waterproof member sealing between an edge of the first housing and one end of the flexible display and a second waterproof member sealing between an edge of the second housing and another end of the flexible display. When the electronic device is changed from the unfolded state to the folded state, as the second area of the heat dissipation member slides, the heat dissipation member may be positioned so that a distance between one end of the second area of the heat dissipation member and the second waterproof member increases.

According to an embodiment, the electronic device may further comprise a first waterproof member sealing between the first housing and a first display area of the flexible display and a second waterproof member sealing between the second housing and a second display area of the flexible display. The heat dissipation member may be positioned in an inner space formed by the first and second housings, the flexible display, and the first and second waterproof members.

According to an embodiment, an end of the heat dissipation member may be disposed adjacent to the first waterproof member, and another end of the heat dissipation member may be positioned adjacent to the second waterproof member.

According to an embodiment, the electronic device may further comprise a guide structure disposed in the second housing or at least one component accommodated in the second housing to guide a slide of the heat dissipation member.

According to an embodiment, the electronic device may further comprise a first hinge plate 351 extending toward the first housing and connected to the hinge structure and a second hinge plate 352 extending toward the second housing and connected to the hinge structure. When the electronic device is changed from the unfolded state to the folded state, the first hinge plate and the second hinge plate may form the same plane as the first housing and the second housing. The heat dissipation member may contact (e.g., adhere to) the first housing and the first hinge plate.

According to an embodiment, the electronic device may further comprise a first hinge plate 371 extending toward the first housing and connected to the hinge structure and a second hinge plate 372 extending toward the second housing and connected to the hinge structure. When the electronic device is changed from the unfolded state to the folded state, the first hinge plate and the second hinge plate may be configured to be movable to support at least a portion of a bending area of the flexible display. The heat dissipation member may be attached to the first housing and be spaced apart from the first hinge plate.

An electronic device 101 according to an embodiment of the disclosure may comprise a first housing 210, a second housing 220, a hinge structure 280 connecting the first housing and the second housing to be rotatable from an unfolded state to a folded state, a flexible display 230 configured to be unfolded or bent based on a relative movement of the second housing with respect to the first housing, a printed circuit board 260 disposed in the first housing, and a heat dissipation member 310 including a first area S1 extending from the first area and overlapping a portion of the first housing and a second area S2 overlapping a portion of the second housing. The heat dissipation member may include a thermally conductive sheet 311 at least partially formed to be slidable and a metal sheet 312 formed to be stacked with the thermally conductive sheet and at least partially bendable.

An electronic device 101 according to an embodiment of the disclosure may comprise a first housing 210, a second housing 220, a hinge structure 280 connected to the first housing and the second housing so that the first housing and the second housing are rotatable while the electronic device is changed between an unfolded state and a folded state, a flexible display 230 accommodated in the first housing and the second housing and positioned to be unfolded or bent while the electronic device is changed between the unfolded state and the folded state, and a heat dissipation member 310 including a first area S1 positioned to overlap at least a portion of the first housing when viewed in a direction perpendicular to the first housing, and a second area S2 extending from the first area and positioned to overlap at least a portion of the second housing when viewed in a direction perpendicular to the second housing. The heat dissipation member may include a thermally conductive sheet 311 at least partially formed to be slidable and a metal sheet 312 attached to the thermally conductive sheet and at least partially bendable.

According to an embodiment, while the electronic device is changed from the unfolded state to the folded state, the heat dissipation member fixed to the first housing may be positioned so that the second area slides with respect to the first area.

According to an embodiment, while the electronic device is changed from the unfolded state to the folded state, one end of the second area of the heat dissipation member may slide toward the hinge structure. An area in which the flexible display and the second housing directly face each other may increase.

According to an embodiment, the thermally conductive sheet may be formed to extend from the first housing to the second housing via the hinge structure, and the metal sheet may be formed in an area corresponding to the thermally conductive sheet.

In a conventional foldable electronic device including a flexible display, a heat dissipation member is disposed only in one housing among a plurality of housings. When the electronic device is folded, as the distance between the housings connected via a hinge structure increases, the heat diffusion through the heat dissipation member disposed in one housing may not reach another area of the flexible display and the different housings.

An electronic device according to an embodiment of the disclosure has a heat dissipation member over the plurality of housings, diffusing the heat generated from a heat source throughout the electronic device.

The electronic device according to an embodiment of the disclosure has a heat dissipation member in which a flexible thermally conductive sheet and a metal sheet are laminated, thus providing elasticity according to the bending of the foldable electronic device and preventing damage to the thermally conductive sheet.

The electronic device according to an embodiment of the disclosure may be formed so that another area is slid with respect to one area of the heat dissipation member fixed to one housing when the foldable electronic device operates from the unfolded state to the folded state. Accordingly, it is possible to provide effective heat diffusion at all times even when the electronic device is in the folded state as well as the unfolded state.

## Claims

1. An electronic device(101), comprising:
a first housing(210);
a second housing(220);
a hinge structure(280) connected to the first housing and the second housing such that the first housing and the second housing are rotatable while the electronic device is in transition between a unfolded state and a folded state;
a flexible display(230) accommodated at the first housing and the second housing, and positioned to be unfolded or bent while the electronic device is in transition between the unfolded state and the folded state;
a processor accommodated in the first housing;
a thermal interface material accommodated in the first housing and positioned between one surface, which faces the flexible display, of the first housing and the processor; and
a heat dissipation member(310) including a first area(S1) positioned to overlap with at least a portion of the first housing, when viewed from a direction perpendicular to the first housing and a second area(S2) extending from the first area and positioned to overlap with at least a portion of the second housing, when viewed from a direction perpendicular to the second housing, and
wherein, while the electronic device is in transition between the unfolded state and the folded state, the first area of the heat dissipation member is fixed to the first housing or at least one component accommodated in the first housing, and the second area of the heat dissipation member is configured to slide with respect to the second housing.

2. The electronic device of claim 1, wherein while the electronic device is changed from the unfolded state to the folded state, at least a portion of the heat dissipation member is positioned to be bent to correspond to the flexible display.

3. The electronic device of claim 1 or 2, wherein while the electronic device is changed from the unfolded state to the folded state, when viewed in a direction perpendicular to the second housing, an area in which the flexible display and the second housing overlap is formed to increase.

4. The electronic device of any one of claims 1 to 3, wherein the heat dissipation member includes:
a thermally conductive sheet (311); and
a bendable metal sheet (312) attached to the thermally conductive sheet.

5. The electronic device of claim 4, further comprising an adhesive sheet (320) for fixing the thermally conductive sheet or the metal sheet to the first housing.

6. The electronic device of claim 4 or 5, wherein the metal sheet has substantially the same area as the thermally conductive sheet.

7. The electronic device of any one of claims 4 to 6, wherein the flexible display (230) includes a first display area (231), a second display area (232), and a folding area (233) connecting the first display area and the second display area, and
wherein when the electronic device is viewed in a direction perpendicular to the flexible display in the unfolded state, the thermally conductive sheet or the metal sheet is disposed to overlap the folding area of the flexible display.

8. The electronic device of any one of claims 1 to 7, wherein the first area of the heat dissipation member is positioned adjacent to a heat source positioned in the first housing.

9. The electronic device of claim 8, wherein the heat dissipation member is positioned so that heat generated from the heat source is transferred to the first area and the second area of the heat dissipation member.

10. The electronic device of any one of claims 1 to 9, further comprising:
a first waterproof member (361) sealing between an edge of the first housing and one end of the flexible display; and
a second waterproof member (362) sealing between an edge of the second housing and another end of the flexible display,
wherein the heat dissipation member is positioned between the first waterproof member and the second waterproof member.

11. The electronic device of any one of claims 1 to 9, further comprising:
a first waterproof member sealing between an edge of the first housing and one end of the flexible display; and
a second waterproof member sealing between an edge of the second housing and another end of the flexible display,
wherein when the electronic device is changed from the unfolded state to the folded state, as the second area of the heat dissipation member slides, the heat dissipation member is positioned so that a distance between one end of the second area of the heat dissipation member and the second waterproof member increases.

12. The electronic device of any one of claims 1 to 9, further comprising:
a first waterproof member sealing between the first housing and a first display area of the flexible display; and
a second waterproof member sealing between the second housing and a second display area of the flexible display,
wherein the heat dissipation member is positioned in an inner space formed by the first and second housings, the flexible display, and the first and second waterproof members.

13. The electronic device of claim 12, wherein the heat dissipation member is positioned so that an end of the heat dissipation member is disposed adjacent to the first waterproof member, and another end of the heat dissipation member is disposed adjacent to the second waterproof member.

14. The electronic device of any one of claims 1 to 13, further comprising a guide structure (410) disposed in the second housing or at least one component accommodated in the second housing to guide a slide of the heat dissipation member.

15. The electronic device of any one of claims 1 to 13, further comprising:
a first hinge plate (351) extending toward the first housing and connected to the hinge structure; and
a second hinge plate (352) extending toward the second housing and connected to the hinge structure,
wherein when the electronic device is changed from the unfolded state to the folded state, the first hinge plate and the second hinge plate form the same plane as the first housing and the second housing, and
wherein the heat dissipation member contacts the first housing and the first hinge plate.

16. The electronic device of any one of claims 1 to 13, further comprising:
a first hinge plate (351) extending toward the first housing and connected to the hinge structure; and
a second hinge plate (352) extending toward the second housing and connected to the hinge structure,
wherein when the electronic device is changed from the unfolded state to the folded state, the first hinge plate and the second hinge plate are configured to support at least a portion of a bending area of the flexible display, and
wherein the heat dissipation member is attached to the first housing and is spaced apart from the first hinge plate.

17. An electronic device (101) comprising:
a first housing (210);
a second housing (220);
a hinge structure (280) connected to the first housing and the second housing so that the first housing and the second housing are rotatable while the electronic device is changed between an unfolded state and a folded state;
a flexible display (230) accommodated in the first housing and the second housing and positioned to be unfolded or bent while the electronic device is changed between the unfolded state and the folded state; and
a heat dissipation member (310) including a first area (S1) positioned to overlap at least a portion of the first housing when viewed in a direction perpendicular to the first housing, and a second area (S2) extending from the first area and positioned to overlap at least a portion of the second housing when viewed in a direction perpendicular to the second housing, wherein the heat dissipation member includes:
a thermally conductive sheet (311) at least partially formed to be slidable; and
a metal sheet (312) attached to the thermally conductive sheet and at least partially bendable.

18. The electronic device of claim 17, wherein while the electronic device is changed from the unfolded state to the folded state, the heat dissipation member fixed to the first housing is positioned so that the second area slides with respect to the first area.

19. The electronic device of claim 17 or 18, wherein while the electronic device is changed from the unfolded state to the folded state, when viewed in a direction perpendicular to the second housing, an area in which the flexible display and the second housing overlap is formed to increase.

20. The electronic device of any one of claims 17 to 19, wherein the metal sheet has substantially the same area as the thermally conductive sheet.
